(19) **Europäisches Patentamt**
**European Patent Office**
**Office européen des brevets**

(11) **EP 2 937 896 B1**

(12) **EUROPEAN PATENT SPECIFICATION**

(45) Date of publication and mention
of the grant of the patent:
**04.05.2022 Bulletin 2022/18**

(21) Application number: **15163216.3**

(22) Date of filing: **01.06.2006**

(51) International Patent Classification (IPC):
*H01L 21/683* (2006.01)   *H01L 27/12* (2006.01)
*H01L 29/06* (2006.01)   *H01L 29/66* (2006.01)
*B82Y 10/00* (2011.01)

(52) Cooperative Patent Classification (CPC):
(C-Sets available)
**H01L 29/0665; B82Y 10/00; H01L 21/6835;**
**H01L 29/0673; H01L 29/1606; H01L 29/22;**
**H01L 29/66742; H01L 29/7781; H01L 29/78696;**
H01L 27/1266; H01L 27/1292; H01L 2221/6835;
H01L 2221/68354; H01L 2221/68368;
H01L 2221/68377;   (Cont.)

(54) **METHOD OF TRANSFERING A PRINTABLE SEMICONDUCTOR ELEMENT**

VERFAHREN ZUR ÜBERTRAGUNG EINES DRUCKBAREN HALBLEITERELEMENTS

METHODE DE TRANSFERT D'UN ELEMENT SEMI-CONDUCTEUR IMPRIMABLE

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **02.06.2005 US 145542**
**02.06.2005 US 145574**
**02.06.2005 PCT/US2005/019354**

(43) Date of publication of application:
**28.10.2015 Bulletin 2015/44**

(60) Divisional application:
**22164385.1**

(62) Document number(s) of the earlier application(s) in
accordance with Art. 76 EPC:
**06771761.1 / 1 915 774**

(73) Proprietor: **The Board of Trustees of the
University of Illinois**
**Urbana, IL 61801 (US)**

(72) Inventors:
• **Nuzzo, Ralph G**
**Champaign, IL 61821 (US)**
• **Rogers, John A.**
**Champaign, IL 61822 (US)**
• **Menard, Etienne**
**73420 Voglans (FR)**

• **Lee, Keon Jae**
**Daejeon 302-772 (KR)**
• **Khang, Dahl-Young**
**Seoul 156-060 (KR)**
• **Sun, Yugang**
**Naperville, IL 60565 (US)**
• **Meitl, Matthew**
**Durham, NC 27713 (US)**
• **Zhu, Zhengtao**
**Rapid City, SD 57702 (US)**
• **Ko, Heung Cho**
**Urbana, IL 61801 (US)**
• **Mack, Shawn**
**Alexandria, VA 22303 (US)**

(74) Representative: **Forresters IP LLP
Skygarden
Erika-Mann-Straße 11
80636 München (DE)**

(56) References cited:
**US-A- 5 817 242      US-A1- 2003 022 403
US-A1- 2004 234 231    US-B1- 6 204 079**

• **YUGANG SUN ET AL: "Fabricating
Semiconductor Nano/Microwires and Transfer
Printing Ordered Arrays of Them onto Plastic
Substrates", NANO LETTERS, vol. 4, no. 10, 1
October 2004 (2004-10-01), pages 1953-1959,
XP55213939, ISSN: 1530-6984, DOI:
10.1021/nl048835l**

**(Cont. next page)**

(52) Cooperative Patent Classification (CPC): (Cont.)
H01L 2924/0002; H01L 2924/1033;
H01L 2924/19041; H01L 2924/30105;
H01L 2924/3025

C-Sets
H01L 2924/0002, H01L 2924/00

**Description**

**BACKGROUND OF INVENTION**

Since the first demonstration of a printed, all polymer transistor in 1994, a great deal of interest has been directed at a potential new class of electronic systems comprising flexible integrated electronic devices on plastic substrates. [Garnier, F., Hajlaoui, R., Yassar, A. and Srivastava, P., Science, Vol. 265, pgs 1684 - 1686] Recently, substantial research has been directed toward developing new solution processable materials for conductors, dielectrics and semiconductors elements for flexible plastic electronic devices. Progress in the field of flexible electronics, however, is not only driven by the development of new solution processable materials but also by new device component geometries, efficient device and device component processing methods and high resolution patterning techniques applicable to plastic substrates. It is expected that such materials, device configurations and fabrication methods will play an essential role in the rapidly emerging new class of flexible integrated electronic devices, systems and circuits.

Interest in the field of flexible electronics arises out of several important advantages provided by this technology. First, the mechanical ruggedness of plastic substrate materials provides electronic devices less susceptible to damage and/or electronic performance degradation caused by mechanical stress. Second, the inherent flexibility of these substrate materials allows them to be integrated into many shapes providing for a large number of useful device configurations not possible with brittle conventional silicon based electronic devices. For example, bendable flexible electronic devices are expected to enable fabrication of new devices, such as electronic paper, wearable computers and large-area high resolution displays, that are not easily achieved with established silicon based technologies. Finally, the combination of solution processable component materials and plastic substrates enables fabrication by continuous, high speed, printing techniques capable of generating electronic devices over large substrate areas at low cost.

The design and fabrication of flexible electronic devices exhibiting good electronic performance, however, present a number of significant challenges. First, the well developed methods of making conventional silicon based electronic devices are incompatible with most plastic materials. For example, traditional high quality inorganic semiconductor components, such as single crystalline silicon or germanium semiconductors, are typically processed by growing thin films at temperatures (> 1000 degrees Celsius) that significantly exceed the melting or decomposition temperatures of most plastic substrates. In addition, most inorganic semiconductors are not intrinsically soluble in convenient solvents that would allow for solution based processing and delivery. Second, although many amorphous silicon, organic or hybrid organic-inorganic semiconductors are compatible with incorporation into plastic substrates and can be processed at relatively low temperatures, these materials do not have electronic properties capable of providing integrated electronic devices capable of good electronic performance. For example, thin film transistors having semiconductor elements made of these materials exhibit field effect mobilities approximately three orders of magnitude less than complementary single crystalline silicon based devices. As a result of these limitations, flexible electronic devices are presently limited to specific applications not requiring high performance, such as use in switching elements for active matrix flat panel displays with non-emissive pixels and in light emitting diodes.

Progress has recently been made in extending the electronic performance capabilities of integrated electronic devices on plastic substrates to expand their applicability to a wider range of electronics applications. For example, several new thin film transistor (TFT) designs have emerged that are compatible with processing on plastic substrate materials and exhibit significantly higher device performance characteristics than thin film transistors having amorphous silicon, organic or hybrid organic-inorganic semiconductor elements. One class of higher performing flexible electronic devices is based on polycrystalline silicon thin film semiconductor elements fabricated by pulse laser annealing of amorphous silicon thin films. While this class of flexible electronic devices provides enhanced device electronic performance characteristics, use of pulsed laser annealing limits the ease and flexibility of fabrication of such devices, thereby significantly increasing costs. Another promising new class of higher performing flexible electronic devices is devices that employ solution processable nanoscale materials, such as nanowires, nanoribbons, nanoparticles and carbon nanotubes, as active functional components in a number of macroelectronic and microelectronic devices.

Use of discrete single crystalline nanowires or nanoribbons has been evaluated as a possible means of providing printable electronic devices on plastic substrates that exhibit enhanced device performance characteristics. Duan et al. describe thin film transistor designs having a plurality of selectively oriented single crystalline silicon nanowires or CdS nanoribbons as semiconducting channels [Duan, X., Niu, C., Sahl, V., Chen, J., Parce, J., Empedocles, S. and Goldman, J., Nature, Vol. 425, pgs, 274 -278]. The authors report a fabrication process allegedly compatible with solution processing on plastic substrates in which single crystalline silicon nanowires or CdS nanoribbons having thicknesses less than or equal to 150 nanometers are dispersed into solution and assembled onto the surface of a substrate using flow-directed alignment methods to produce the semiconducting element of at thin film transistor. An optical micrograph provided by the authors suggests that the disclosed fabrication process prepares a monolayer of nanowires or nanoribbons in a substantially parallel orientation and spaced apart by about 500 nanometers to about 1,000 nanometers. Although the authors report relatively high intrinsic field affect mobilities for individual nanowires or nanoribbons ($\approx 119$ cm$^2$ V$^{-1}$ S$^{-1}$),

the overall device field effect mobility has recently been determined to be "approximately two orders of magnitude smaller" than the intrinsic field affect mobility value reported by Duan et al. [Mitzi, D.B, Kosbar, L.L., Murray, C.E., Copel, M. Afzali, A., Nature, Vol. 428, pgs. 299-303]. This device field effect mobility is several orders of magnitude lower than the device field effect mobilities of conventional single crystalline inorganic thin film transistors, and is likely due to practical challenges in aligning, densely packing and electrically contacting discrete nanowires or nanoribbons using the methods and device configurations disclosed in Duan et al.

Use of nanocrystal solutions as precursors to polycrystalline inorganic semiconductor thin films has also been explored as a possible means of providing printable electronic devices on plastic substrates that exhibit higher device performance characteristics. Ridley et al. disclose a solution processing fabrication method wherein a solution cadmium selenide nanocrystals having dimensions of about 2 nanometers is processed at plastic compatible temperatures to provide a semiconductor element for a field effect transistor. [Ridley, B.A., Nivi, B. and Jacobson, J.M., Science, Vo. 286, 746 - 749 (1999)] The authors report a method wherein low temperature grain growth in a nanocrystal solution of cadmium selenide provides single crystal areas encompassing hundreds of nanocrystals. Although Ridley et al. report improved electrical properties relative to comparable devices having organic semiconductor elements, the device mobilities achieved by these techniques ($\approx$ 1 cm$^2$ V$^{-1}$ S$^{-1}$) are several orders of magnitude lower than the device field effect mobilities of conventional single crystalline inorganic thin film transistors. Limits on the field effect mobilities achieved by the device configurations and fabrication methods of Ridley et al. are likely to arise from the electrical contact established between individual nanoparticles. Particularly, the use of organic end groups to stabilize nanocrystal solutions and prevent agglomeration may impede establishing good electrical contact between adjacent nanoparticles that is necessary for providing high device field effect mobilities.

Although Duan et al. and Ridley et al. provide methods for fabricating thin film transistors on plastic substrates, the device configurations described employ transistors comprising mechanically rigid device components, such as electrodes, semiconductors and/or dielectrics. Selection of a plastic substrate with good mechanical properties may provide electronic devices capable of performing in flexed or distorted orientations. However, such motion is expected to generate mechanical strain on the individual rigid transistor device components. This mechanical strain may induce damage to individual components, for example by cracking, and also may degrade or disrupt electrical contact between device components.

U.S. Patents 11/145,574 and 11/145,542, both filed on June 2, 2005, disclose a high yield fabrication platform using printable semiconductor elements for making electronic devices, optoelectronic devices and other functional electronic assemblies by versatile, low cost and high area printing techniques. The disclosed methods and compositions provide for the transfer, assembly and/or and integration of microsized and/or nanosized semiconductor structures using dry transfer contact printing and/or solution printing techniques providing good placement accuracy, registration and pattern fidelity over large substrate areas. The disclosed methods provide important processing advantages enabling the integration of high quality semiconductor materials fabricated using conventional high temperature processing methods onto substrates by printing techniques which may be independently carried out at relatively low temperatures (< about 400 degrees Celsius) compatible with a range of useful substrate materials, including flexible plastic substrates. Flexible thin film transistors fabricated using printable semiconductor materials exhibit good electronic performance characteristics, such as device field effect mobilities greater than 300 cm$^2$ V$^{-1}$ s$^{-1}$ and on/off ratios greater than 10$^3$, when in flexed and non-flexed conformations.

It will be appreciated from the foregoing that methods of making high quality printable semiconductor elements from low cost, bulk starting materials will enhance the commercial attractiveness of printing technologies for generating large area, flexible electronic and optoelectronic devices and device arrays. Further, printable semiconductor compositions and printing-based assembly methods enabling a high degree of control over the physical dimensions, spatial orientations and registration of semiconductor elements printed onto substrates will also enhance the applicability of these methods for fabricating a broad range of functional devices.

US2004/234231 discloses a method for a three-dimensional structural body which includes sequentially bonding/transferring and laminating plural cross-sectional form members.

## SUMMARY OF INVENTION

The present invention is set out in the claims. In particular, the present invention is as follows:
a method of transferring a printable semiconductor element (300), said method comprising the steps of:

    providing a printable semiconductor structure (290) comprising a printable semiconductor element (300); and at least one bridge element (310) connected to said printable semiconductor element (300) and connected to a mother wafer (320), wherein said printable semiconductor element (300) and said bridge element (310) are at least partially undercut from said mother wafer (320); wherein said first bridge element (310) connects to less than the entire width or cross sectional area of a first end of said printable semiconductor element (300);

contacting said printable semiconductor element (300) with a conformable transfer device having a contact surface, wherein contact between said contact surface and said printable semiconductor element (300) binds said printable semiconductor element (300) to said contact surface; and

moving said conformable transfer device in a manner resulting in the fracture of said bridge element (310), thereby transferring said printable semiconductor element (300) from said mother wafer (320) to said conformable transfer device; thereby forming said contact surface having said printable semiconductor element (300) disposed thereon; contacting said printable semiconductor element (300) disposed on said contact surface with a receiving surface of a substrate; and

separating said contact surface of said conformable transfer device and said printable semiconductor element (300), thereby transferring said printable semiconductor element (300) onto said receiving surface of said substrate.

## BRIEF DESCRIPTION OF THE DRAWINGS

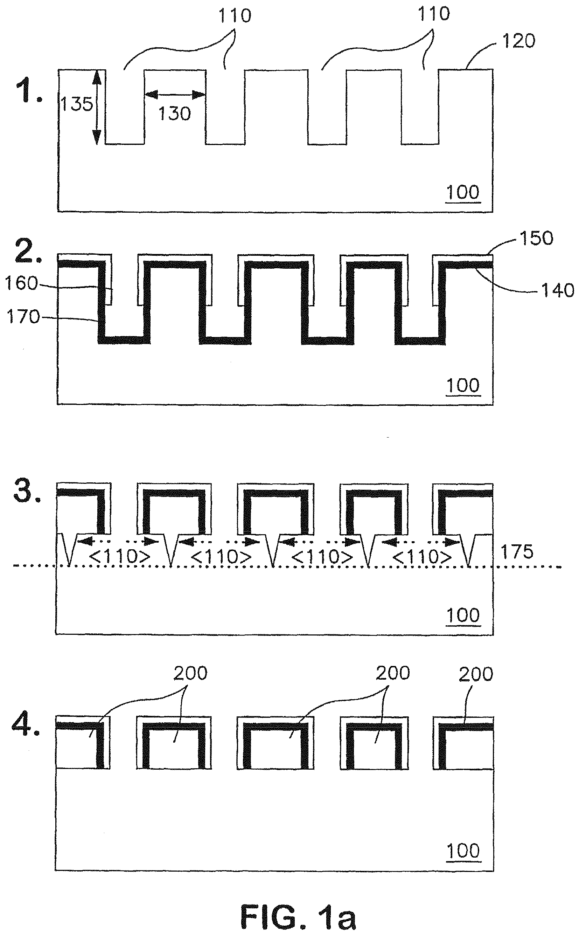

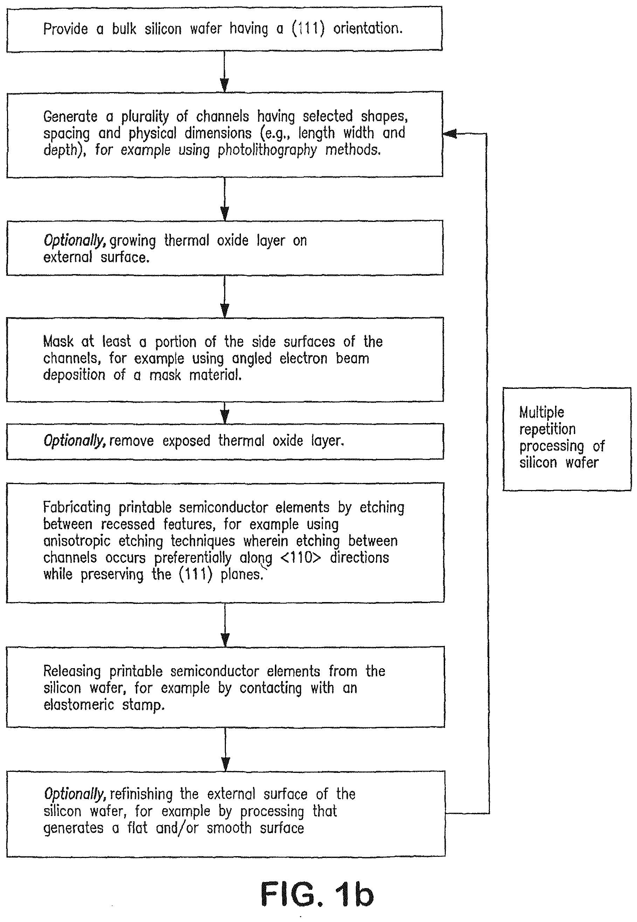

**Fig. 1A** provides a schematic cross section view diagram illustrating exemplary methods of the present disclosure for making printable semiconductor elements comprising ribbons of single crystalline silicon from a bulk silicon wafer having a (111) orientation. **Fig. 1B** provides a flow diagram setting forth processing steps in the present methods for generating printable semiconductor elements from bulk silicon wafers.

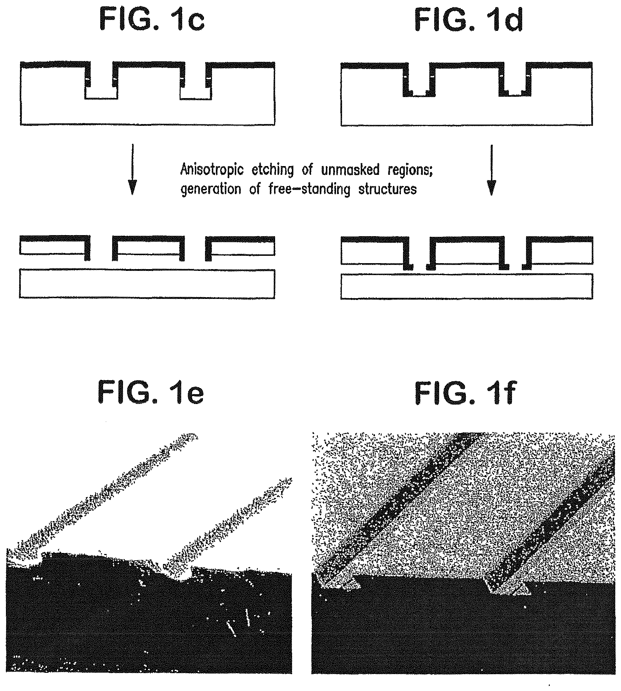

**Figure 1C** provides a cross sectional view schematic processing diagram illustrating fabrication methods wherein the side surfaces of recessed features are partially, but not completely, masked. **Figure 1D** provides a cross sectional view schematic processing diagram illustrating fabrication methods wherein the side surfaces of recessed features are completely masked.

**Figure 1E** provides an image of recessed features in Si (111) having a trench configuration generated without side surface refining. The recessed features shown in Figure **1E** were defined by phase shift photolithography, metal lift-off and reactive ion etching, and subsequent removal of metal etch mask. **Figure 1F** provides an image of recessed features in Si (111) having a trench configuration generated with side surface refining.

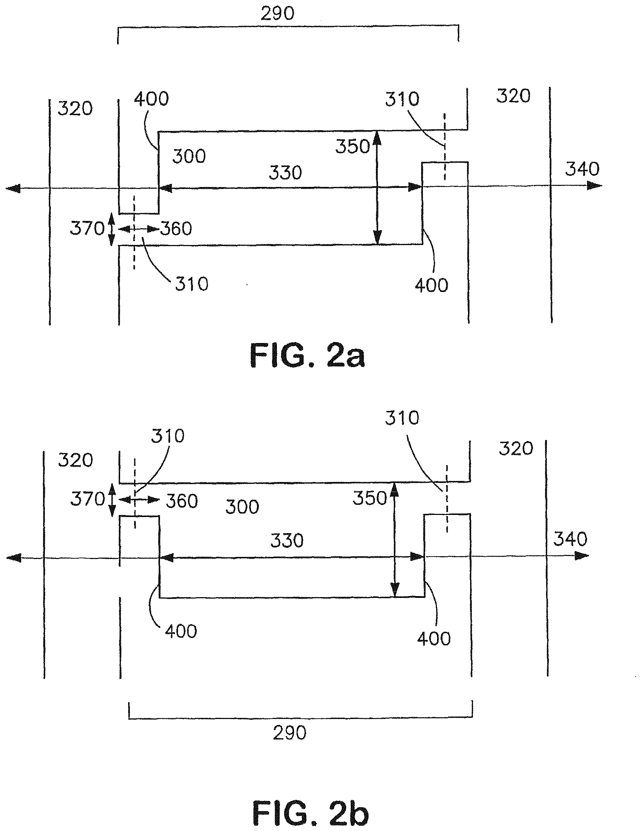

**Figs. 2A and 2B** provide schematic top plan view diagrams of printable semiconductor structures of the present disclosure comprising a printable semiconductor element and two bridge elements. Bridge elements are positioned distal to each other in the structure shown in Figure 2A, and bridge elements are positioned proximal to each other in the structure shown in Figure 2B.

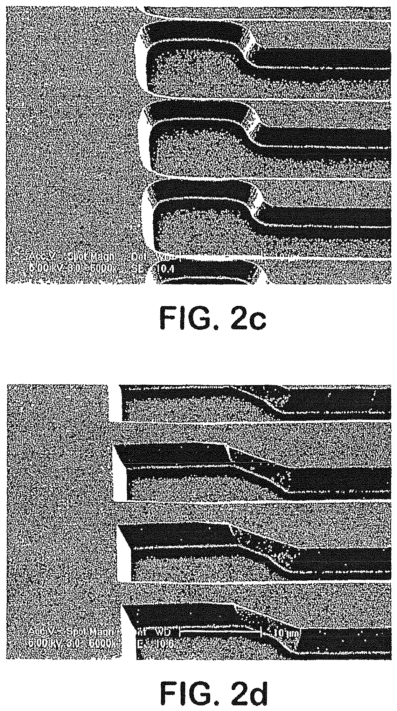

**Figures 2C and 2D** provide images of bridge elements connecting a printable semiconductor element to a mother wafer.

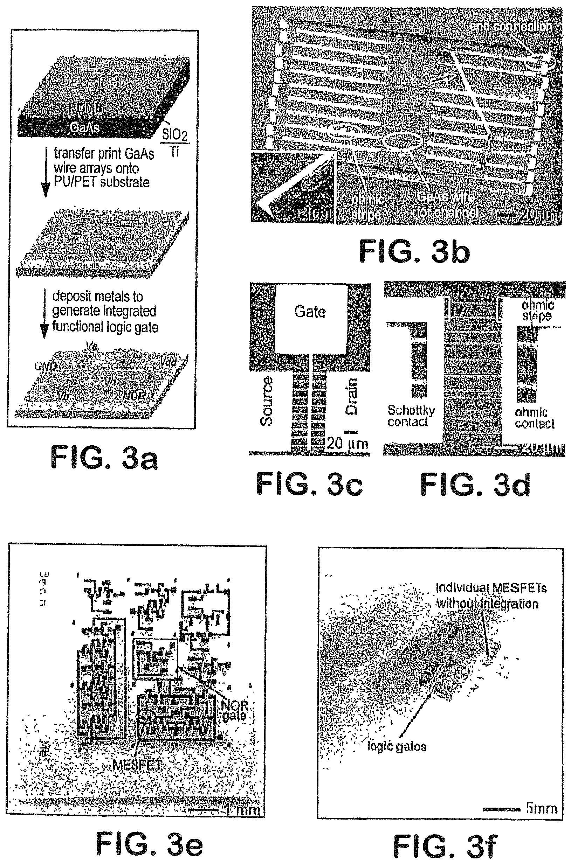

**Fig. 3. (a)** Schematic illustration of the process for fabricating transistors, diodes and logic circuits on plastic using transfer printed GaAs wires integrated with ohmic stripes, prepared from a single-crystalline GaAs wafer. **(b)** SEM image of an array of GaAs wires (with ohmic stripes) with their ends connecting to the mother wafer. The partial wire indicated by the arrow lies underneath the arrayed wires, indicating that the GaAs wires are separated from the bulk wafer. The inset presents a free-standing individual wire, clearly showing its triangular cross section, **(c)** SEM image of an individual MESFET with channel length of 50 $\mu$m and gate length of 5 $\mu$m, formed with the GaAs wire array shown in **(b)** transfer printed on a PET substrate. **(d)** Optical micrograph of a Ti/n-GaAs Schottky diode on a PET sheet. The insets show that one electrode pad connects the ohmic stripes on one end of the wires while the other electrode (150 nm Ti/150 nm Au) pad directly connects to the GaAs wires for forming Schottky contacts. **(e, f)** Optical images of PET substrates with various logic gates and individual MESFETs mounted on a flat surface **(e)** and on the curved shaft of a white marker **(f).**

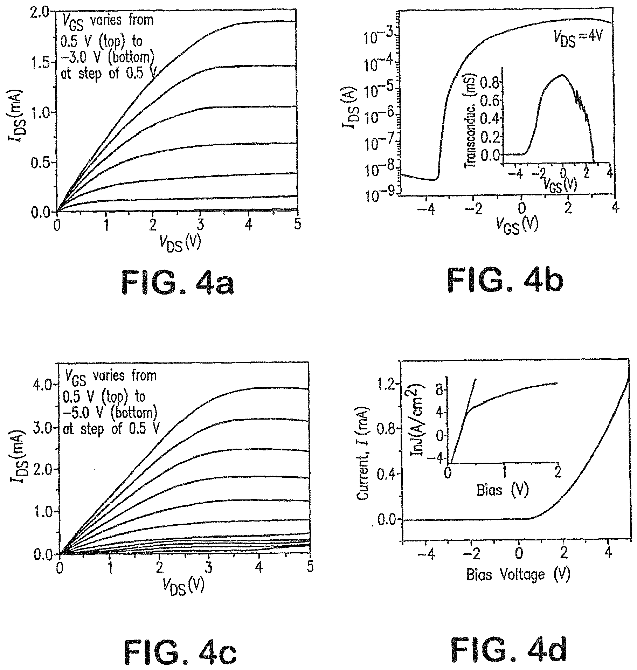

**Fig. 4.** Characterization of GaAs-wire MESFETs with a gate length of 5 $\mu$m and different channel lengths: **(a, b)** 50 $\mu$m and **(c)** 25 $\mu$m on PU/PET substrates. **(a)** Current-voltage (i.e., $I_{DS}$ versus $V_{DS}$) curves of the transistor shown in **Fig. 3c** at different gate voltage ($V_{GS}$). From top to bottom, the $V_{GS}$ decreases from 0.5 to -3.0 V at a step of 0.5 V. **(b)** Transfer curve of the same transistor in the saturation region of $V_{DS}$ = 4V. The inset shows the derivative of the transfer curve, revealing the dependence of the transconductance on the gate voltage. **(c)** Source-drain current at different $V_{GS}$ for a transistor with channel length of 25 $\mu$m. From top to bottom, the $V_{GS}$ decreases from 0.5 to -5.0 V at a step of 0.5 V. **(d)** $I$-$V$ characteristics of the as-fabricated Au/Ti-GaAs Schottky diodes, showing good rectifying capabilities.

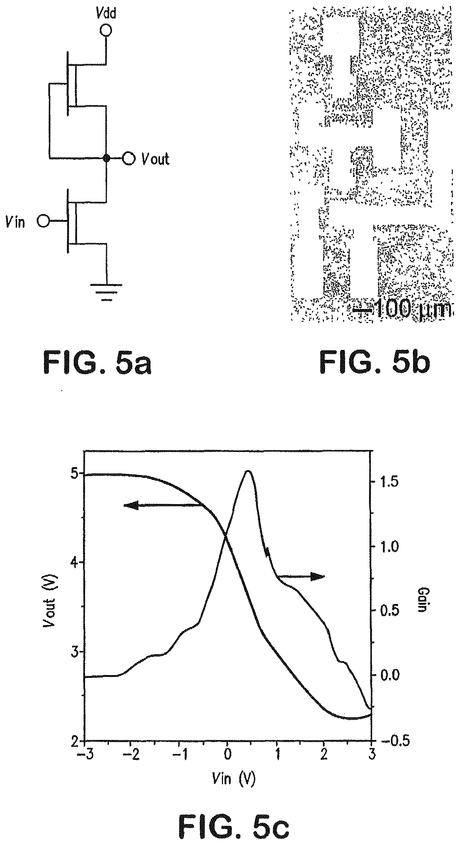

**Fig. 5:** Circuit diagram **(a),** optical image **(b),** and output-input characteristics (c) of an inverter. All MESFETs have a gate length of 5 $\mu$m. The $V_{dd}$ was biased to 5 V versus ground (GND).

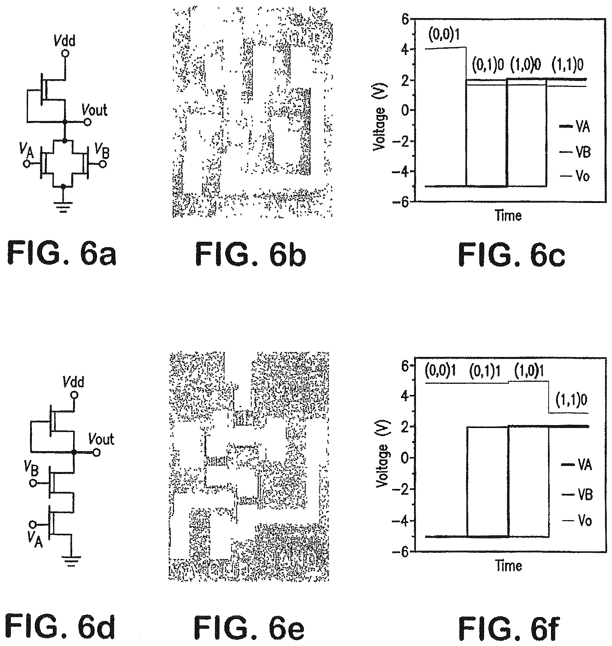

**Fig. 6:** Circuit diagrams, optical images, and output-input characteristics of different logic gates: **(a, b, c)** NOR gate; **(d, e, f)** NAND gate. All MESFETs have a gate length of 5 $\mu$m. The scale bars represent 100 $\mu$m. $V_{dd}$ applied to these logic gates was 5 V versus ground (GND). The logic "0" and "1" input signals of the NOR and NAND gates were driven by -5 and 2 V, respectively. The logic "0" and "1" outputs of the NOR gate are 1.58-1.67 V and 4.1 V, respectively. The logic "0" and "1" outputs of the NAND gate are 2.90 V and 4.83-4.98 V, respectively.

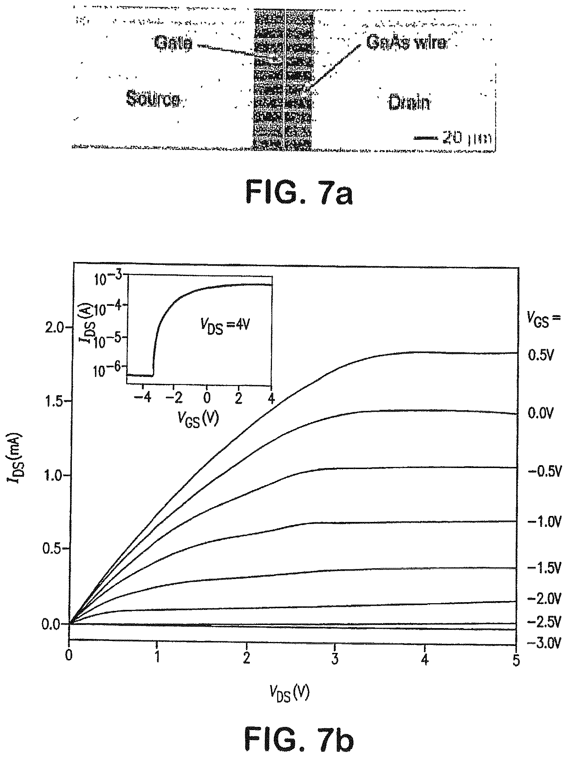

**FIG. 7: (a)** SEM image of an individual GaAs-wire MESFET with channel length of 50 $\mu$m and gate length of 2 $\mu$m on PU/PET substrate, showing each transistor is formed with ten aligned GaAs wires, **(b)** Current-voltage (i.e., $I_{DS}$ versus $V_{Ds}$) curves of a transistor shown in **(a).** From top to bottom, the $V_{GS}$ decreases from 0.5 to -3.0 V at a step of 0.5 V. The inset shows the transfer curve of this transistor in the saturation region of $V_{DS}$ = 4 V.

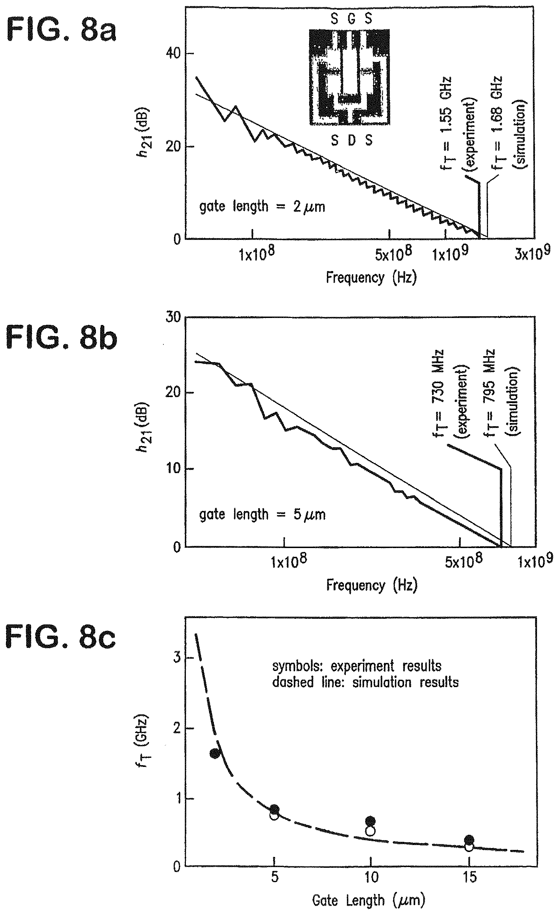

**FIG. 8: (a, b)** Experimental (blue) and simulated (red) results of RF responses of GaAs-wire MESFETs with different gate lengths: 2 $\mu$m (a) and 5 $\mu$m **(b).** The measurements are conducted with probing configuration shown in the inset of **(a). (c)** Dependence of $f_T$ on gate length. The different symbols represent measurements on different devices; the dashed line corresponds to simulation.

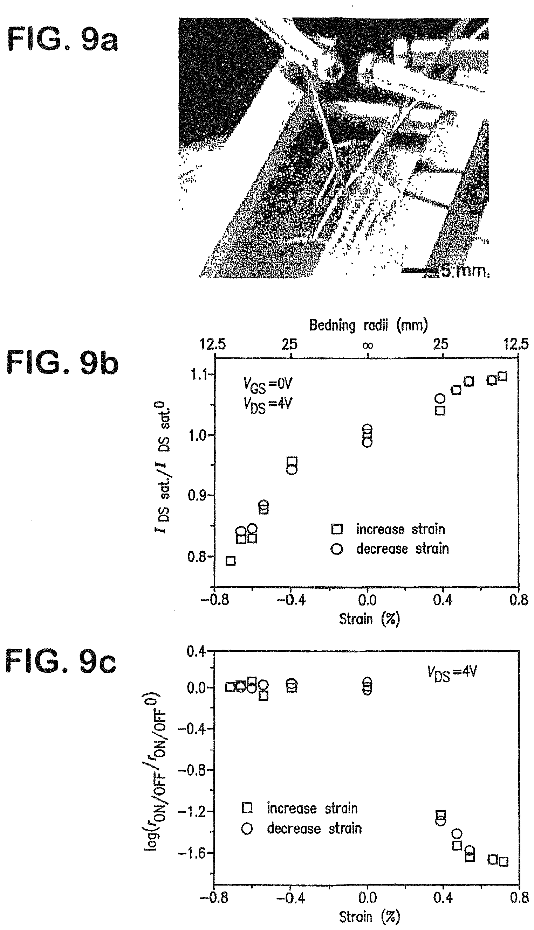

**FIG. 9:** Characterization of the mechanical flexibility of high speed GaAs-wire MESFETs (with gate length of 2 $\mu$m) on PU/PET substrates. **(a)** Optical image of the setup for the measurements. The effects of surface strain (positive and negative values correspond to tensile and compressive strains, respectively) on **(b)** the saturated current flow through source to drain at $V_{DS}$ = 4V and $V_{GS}$ = 0 V; and **(c)** the ON/OFF current ratio in the saturation region of $V_{DS}$ = 4 V.

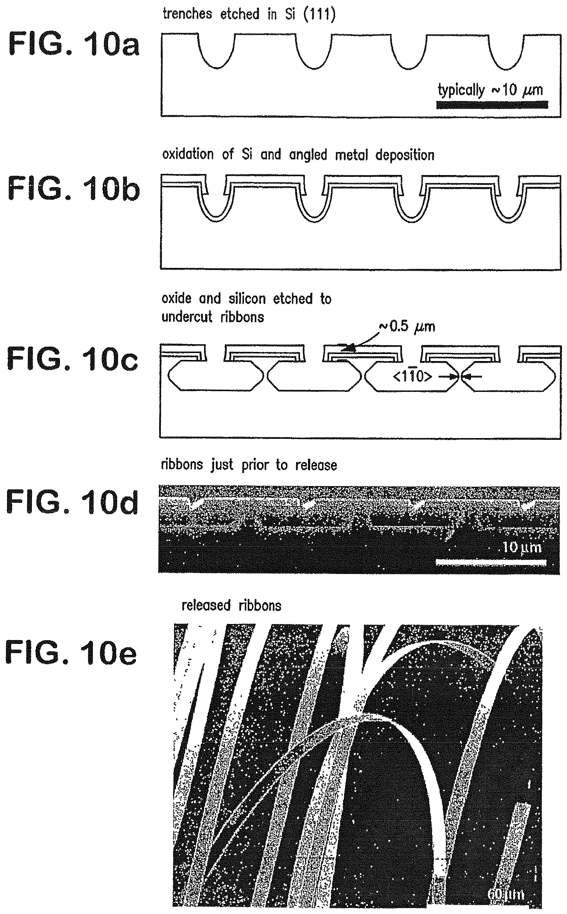

**FIG. 10:** Schematic process flow of single-crystal silicon ribbon fabrication. **(a)** An $SF_6$ plasma etches trenches in a (111) Si surface. **(b)** Thermal oxidation and angled evaporation of Ti/Au layers passivate the side surfaces, **(c)** Finally, a hot KOH/IPA/$H_2$0 solution undercuts the Si ribbons. **(d)** Cross-sectional SEM image of partially undercut ribbons. (e) Released, flexible ribbons.

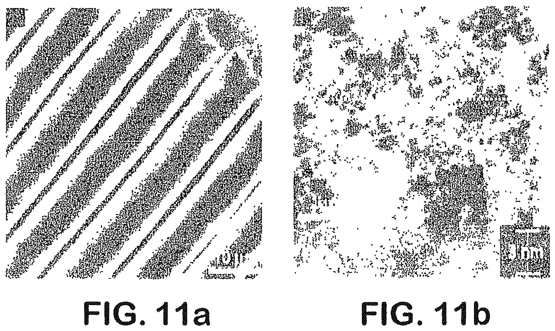

**FIG. 11:** Atomic force microscopy of microstructured silicon generated by anisotropic wet etch undercut. **(a)** AFM height image of ribbons on a PDMS stamp, with the underside exposed. Ribbons are 115 to 130 nm thick, as measured at their edges, and bow downward in the middle. **(b)** AFM image of the underside of a 550 nm-thick ribbon revealing nanoscale roughness introduced by the KOH/IPA/$H_2$0 undercut.

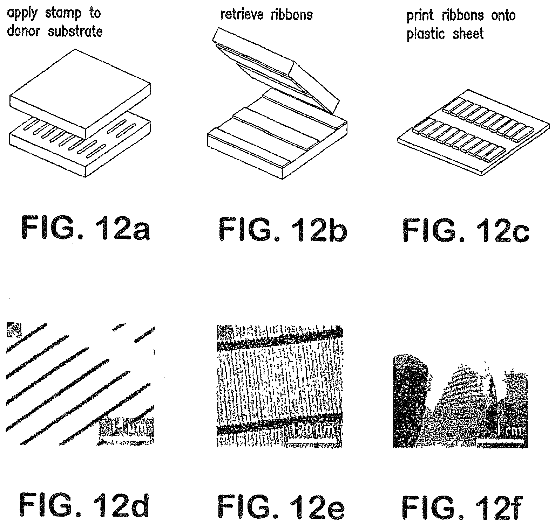

**FIG. 12:** Schematic process flow for transferring microstructured silicon from a "donor" wafer to a plastic substrate. **(a)** A PDMS stamp laminates against a chip with undercut ribbons that are anchored to the wafer. **(b)** Ribbons bond to the stamp and can be removed from the wafer by peeling away the stamp. **(c)** Ribbons are then printed from the stamp to a plastic substrate. **(d)** SEM image of near-completely-undercut ribbons anchored to the donor wafer, **(e)** Optical micrograph of ribbons removed from the donor and adhered to the stamp. **(f)** Photograph of a flexible plastic "chip" that houses TFTs made from transferred silicon ribbons.

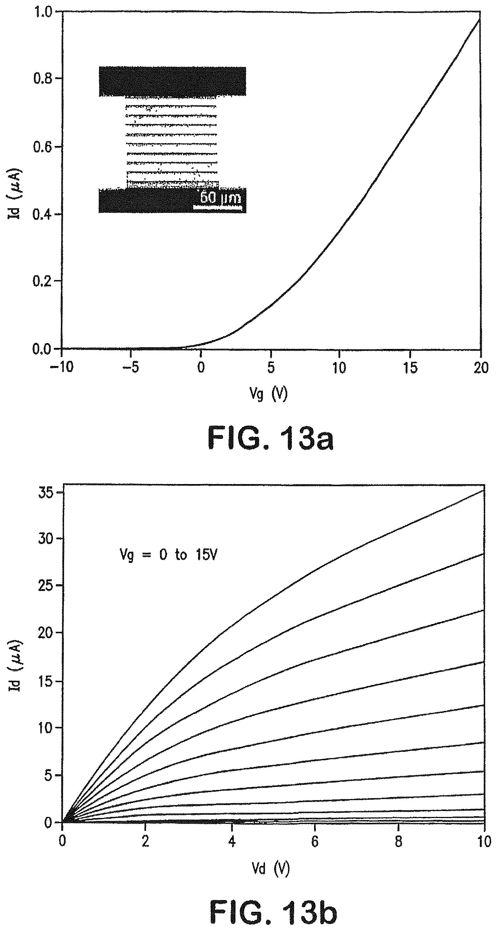

**FIG. 13:** Electrical characterization of a single-crystalline silicon bottom-gate transistor on a PET/ITO substrate; L=100 um, W=100 um, linear mobility 360 cm$^2$V$^{-1}$s$^{-1}$; saturation mobility 100 cm$^2$V$^{-1}$s$^{-1}$ **(a)** transfer characteristics (VD=0.1 V) showing ~4000 on/off ratio with inset top-view of a device. **(b)** current-voltage (I-V) characteristics.

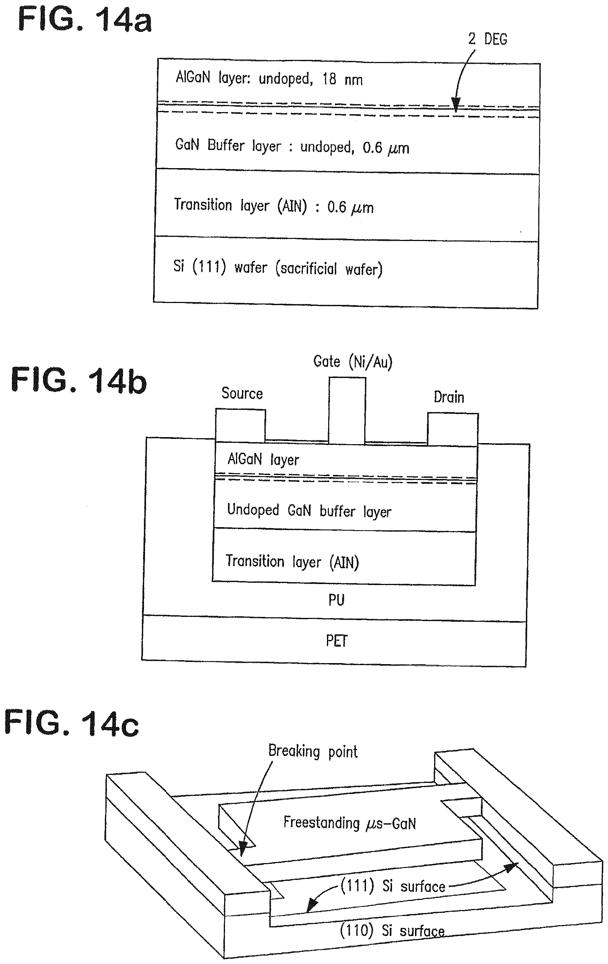

**Fig. 14:** Schematic illustration of **(a)** heterostructure GaN wafer for fabricating high electron mobility transistors (HEMTs, two dimensional electron gas (2 DEG) formed between AlGaN and GaN interface); **(b)** HEMTs geometry on plastic substrate; (c) the Ws-GaN design that is supported by two 'narrow bridges' at the end of Ws-GaN ribbon. Smart anisotropic etching orientation is used to make freestanding Ws-GaN elements.

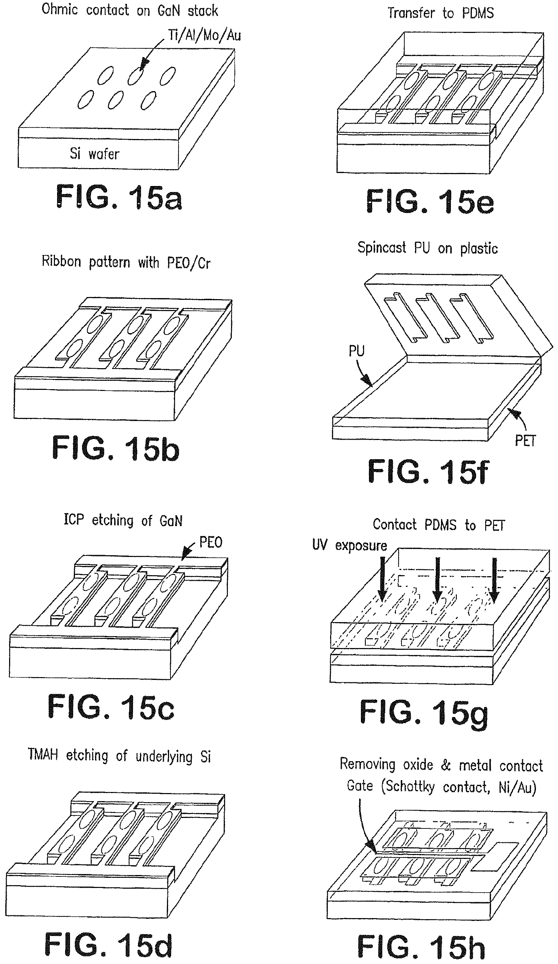

**Fig. 15:** Schematic illustration of steps for fabrication of Ws-GaN HEMTs onto plastic substrate.

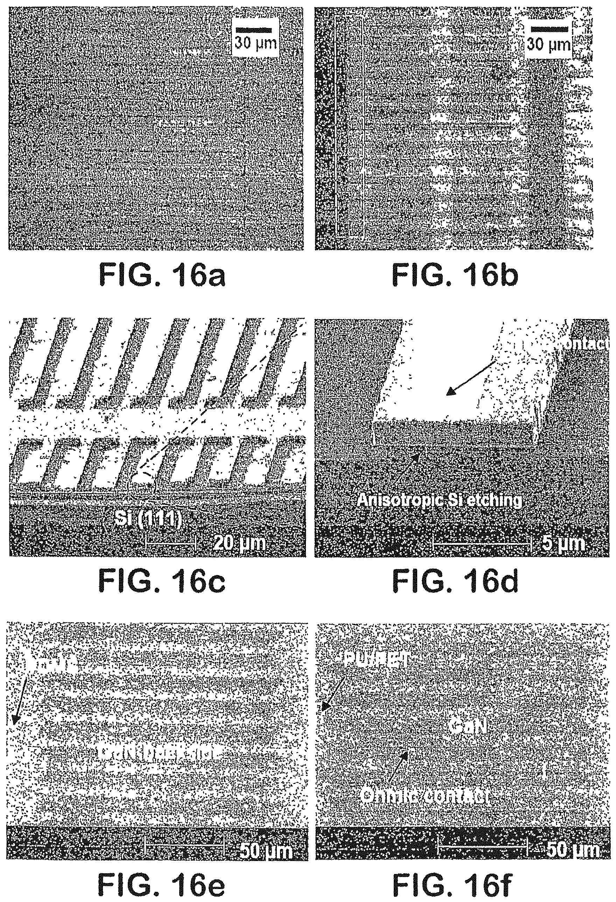

**Fig. 16: (a)** GaN wafer before TMAH wet etching of underlying Si. **(b)** Freestanding GaN ribbon after TMAH etching. Note the color difference between the etched and non etched area of sacrificial Si layer. **(c-d)** SEM images of intermediate step of TMAH anisotropic etching of underlying Si. **(e)** An SEM image of PDMS slab inked with $\mu$s-GaN objects by a van der waals force. **(f)** An SEM image of $\mu$s-GaN transferred to PU coated PET. The metal and polymer areas are artificially colorized for ease of viewing.

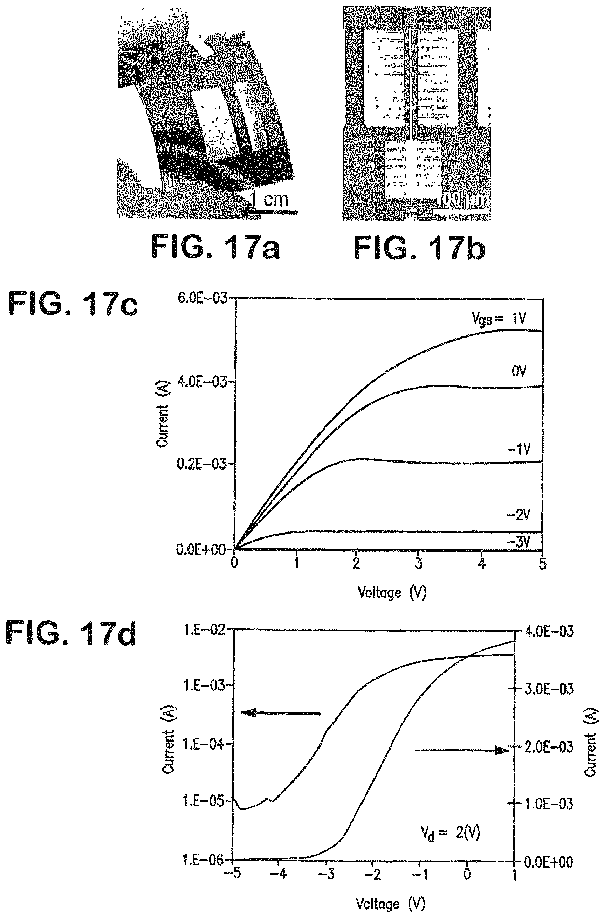

**Fig. 17:** High performance HEMTs formed from the Ws-GaN on plastic substrate. **(a-b)** Optical micrographs of actual flexible Ws-GaN devices. Schematic illustration of cross section device geometry is shown in **Fig. 14B:. (c)** I-V curves of Ws-GaN based HEMTs at a range of gate voltage (Vg= -4 V to 1 V). The channel length, the channel width and gate width of the device were 20 Wm, 170 Wm, and 5 Wm respectively. **(d)** The transfer characteristics, measured at a constant source-drain voltage ($V_{ds}$=2V), indicated the transconductance of 1.5 mS

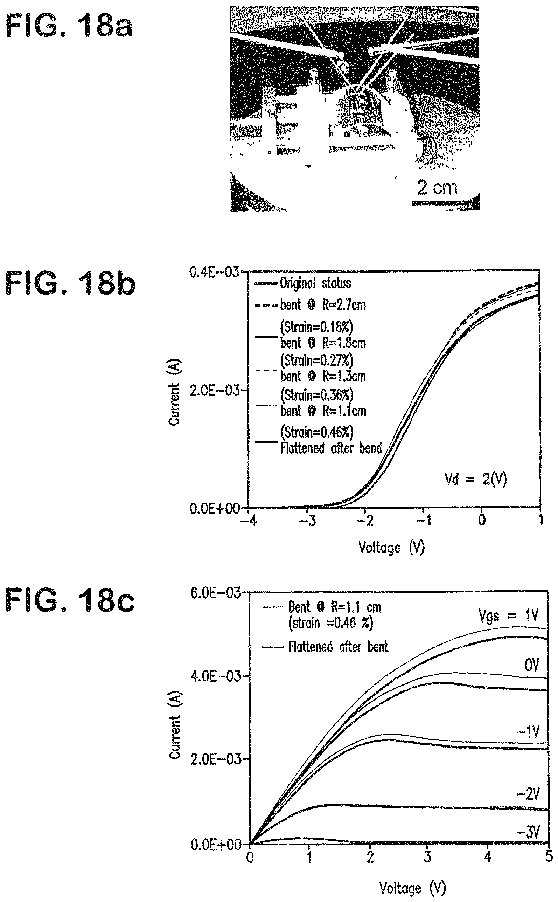

**Fig. 18 (a)** An optical image of the actual bending stage and plastic device. **(b)** Transfer curves obtained at different bending radii (and its corresponding strains). (c) I-V curves obtained when the plastic sheet is bent at maximum bending radius (orange) and flattened after bending cycles (blue).

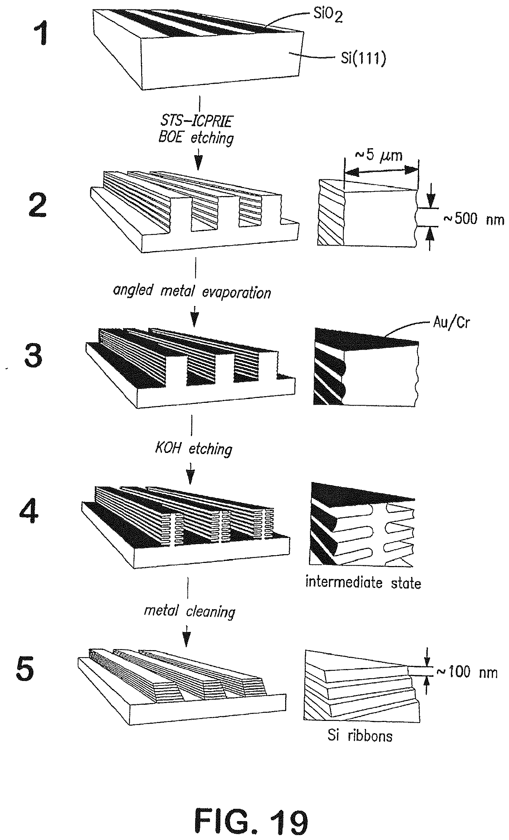

**Fig. 19** provides a process flow schematic illustrating a method of the present disclosure for making multilayer arrays of printable semiconductor elements.

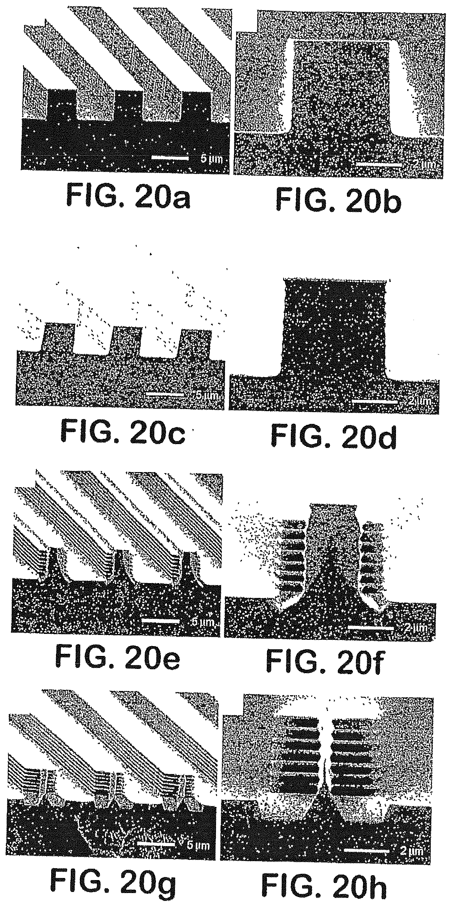

**Fig. 20** provides SEM images of Si (111) in angled-view (a, c, e, g) and cross-sectional view (b, d, f, h): (a and b) after STS-ICPRIE and BOE etching, (c and d) after metal protection on the side surfaces, (e through h) after KOH etching for 2 min (e and f) and 5 min (g and h) followed by metal cleaning.

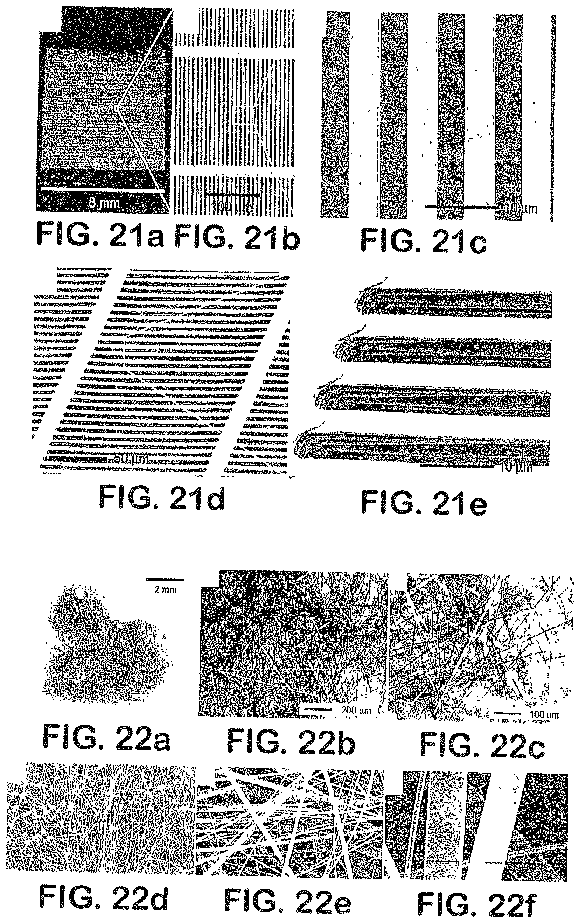

**Fig. 21** provides (a) provides a photograph of a large-scale aligned array of four-layered Si (111) ribbons. (b and c) Top-view and (d and e) angled-view SEM images of the four-layered Si (111) shown in (a).

**Fig. 22** provides (a) Photograph and (b and c) OM images of released flexible Si (111) ribbons. (d to f) SEM images of the ribbons shown in (a).

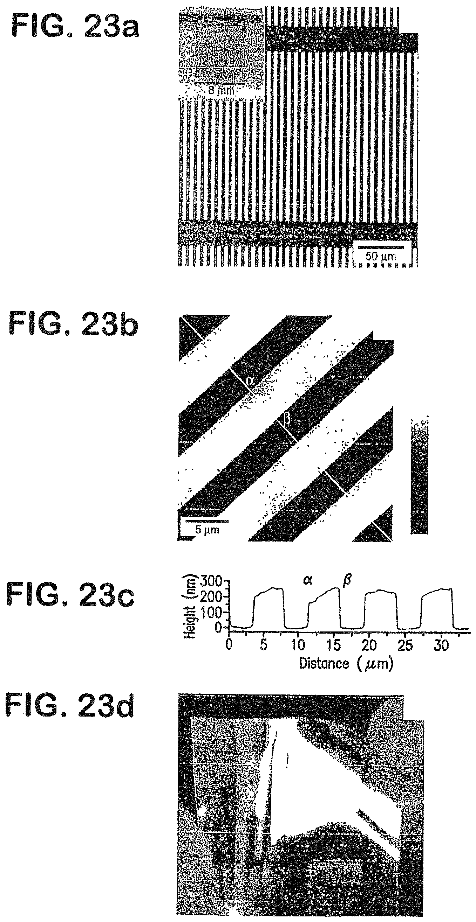

**Fig. 23** provides (a) Optical images of aligned Si (111) ribbons transferred on PDMS substrate. (b) AFM image of four ribbons from the array shown in (a). (c) Photograph of a flexible polyester film that houses four patterns of Si (111) arrays from four cycles of transferring from a single Si chip.

## DETAILED DESCRIPTION OF THE INVENTION

Referring to the drawings, like numerals indicate like elements and the same number appearing in more than one drawing refers to the same element. In addition, hereinafter, the following definitions apply:

"Printable" relates to materials, structures, device components and/or integrated functional devices that are capable of transfer, assembly, patterning, organizing and/or integrating onto or into substrates without exposure of the substrate to high temperatures (i.e. at temperatures less than or equal to about 400 degrees Celsius). In one aspect of the present disclosure, printable materials, elements, device components and devices are capable of transfer, assembly, patterning, organizing and/or integrating onto or into substrates via solution printing or dry transfer contact printing.

"Printable semiconductor elements" of the present disclosure comprise semiconductor structures that are able to be assembled and/or integrated onto substrate surfaces, for example using by dry transfer contact printing and/or solution printing methods. In one aspect of the present disclosure, printable semiconductor elements of the present disclosure are unitary single crystalline, polycrystalline or microcrystalline inorganic semiconductor structures. In one aspect of the present disclosure, printable semiconductor elements are connected to a substrate, such as a mother wafer, via one or more bridge elements. In this context of this description, a unitary structure is a monolithic element having features that are mechanically connected. Semiconductor elements of the present disclosure may be undoped or doped, may have a selected spatial distribution of dopants and may be doped with a plurality of different dopant materials, including P and N type dopants. The present disclosure includes microstructured printable semiconductor elements having at least one cross sectional dimension greater than or equal to about 1 micron and nanostructured printable semiconductor elements having at least one cross sectional dimension less than or equal to about 1 micron. Printable semiconductor elements useful in many applications comprises elements derived from "top down" processing of high purity bulk materials, such as high purity crystalline semiconductor wafers generated using conventional high temperature processing techniques. In one aspect of the present disclosure, printable semiconductor elements of the present disclosure comprise composite structures having a semiconductor operational connected to at least one additional device component or structure, such as a conducting layer, dielectric layer, electrode, additional semiconductor structure or any combination of these. In one aspect of the present disclosure, printable semiconductor elements of the present disclosure comprise stretchable semiconductor elements and/or heterogeneous semiconductor elements.

"Cross sectional dimension" refers to the dimensions of a cross section of device, device component or material. Cross sectional dimensions include width, thickness, radius, and diameter. For example, printable semiconductor elements having a ribbon shape are characterized by a length and two cross sectional dimensions; thickness and width. For example, printable semiconductor elements having a cylindrical shape are characterized by a length and the cross sectional dimension diameter (alternatively radius).

"Longitudinally oriented in a substantially parallel configuration" refers to an orientation such that the longitudinal axes of a population of elements, such as printable semiconductor elements, are oriented substantially parallel to a selected alignment axis. In the context of this definition, substantially parallel to a selected axis refers to an orientation within 10 degrees of an absolutely parallel orientation, more preferably within 5 degrees of an absolutely parallel orientation.

The terms "flexible" and "bendable" are used synonymously in the present description and refer to the ability of a material, structure, device or device component to be deformed into a curved shape without undergoing a transformation that introduces significant strain, such as strain characterizing the failure point of a material, structure, device or device component. In an exemplary aspect of the present disclosure, a flexible material, structure, device or device component may be deformed into a curved shape without introducing strain larger than or equal to about 5 %, preferably for some applications larger than or equal to about 1 %, and more preferably for some applications larger than or equal to about 0.5 %.

"Semiconductor" refers to any material that is a material that is an insulator at a very low temperature, but which has a appreciable electrical conductivity at a temperatures of about 300 Kelvin. In the present description, use of the term semiconductor is intended to be consistent with use of this term in the art of microelectronics and electrical devices. Semiconductors useful in the present disclosure may comprise element semiconductors, such as silicon, germanium and diamond, and compound semiconductors, such as group IV compound semiconductors such as SiC and SiGe, group III-V semiconductors such as AlSb, AlAs, Aln, AlP, BN, GaSb, GaAs, GaN, GaP, InSb, InAs, InN, and InP, group III-V ternary semiconductors alloys such as $Al_xGa_{1-x}As$, group II-VI semiconductors such as CsSe, CdS, CdTe, ZnO, ZnSe, ZnS, and ZnTe, group I-VII semiconductors CuCl, group IV - VI semiconductors such as PbS, PbTe and SnS, layer semiconductors such as $PbI_2$, $MoS_2$ and GaSe, oxide semiconductors such as CuO and $Cu_2O$. The term semiconductor includes intrinsic semiconductors and extrinsic semiconductors that are doped with one or more selected materials, including semiconductor having p-type doping materials and n-type doping materials, to provide beneficial electrical properties useful for a given application or device. The term semiconductor includes composite materials comprising a mixture of semiconductors and/or dopants. Specific semiconductor materials useful for in some applications of the present disclosure include, but are not limited to, Si, Ge, SiC, AlP, AlAs, AlSb, GaN, GaP, GaAs, GaSb, InP, InAs, GaSb, InP, InAs, InSb, ZnO, ZnSe, ZnTe, CdS, CdSe, ZnSe, ZnTe, CdS, CdSe, CdTe, HgS, PbS, PbSe, PbTe, AlGaAs, AllnAs, AllnP, GaAsP, GaInAs, GaInP, AlGaAsSb, AlGaInP, and GaInAsP. Porous silicon semiconductor materials are useful for applications of the present disclosure in the field of sensors and light emitting materials, such as light emitting diodes (LEDs) and solid state lasers. Impurities of semiconductor materials are atoms, elements, ions and/or molecules other than the semiconductor material(s) themselves or any dopants provided to the semiconductor material. Impurities are undesirable materials present in semiconductor materials which may negatively impact the electrical properties of semiconductor materials, and include but are not limited to oxygen, carbon, and metals including heavy metals. Heavy metal impurities include, but are not limited to, the group of elements between copper and lead on the periodic table, calicum, sodium, and all ions, compounds and/or complexes thereof.

"Good electronic performance" and "high performance" are used synonymously in the present description and refer to devices and device components have electronic characteristics, such as field effect mobilities, threshold voltages and on - off ratios, providing a desired functionality, such as electronic signal switching and/or amplification. Exemplary printable semiconductor elements of the present disclosure exhibiting good electronic performance may have intrinsic field effect mobilities greater than or equal 100 $cm^2$ $V^{-1}$ $S^{-1}$, preferably for some applications greater than or equal to about 300 $cm^2$ $V^{-1}$ $S^{-1}$. Exemplary transistors of the present disclosure exhibiting good electronic performance may have device field effect mobilities great than or equal to about 100 $cm^2$ $V^{-1}$ $S^{-1}$, preferably for some applications greater than or equal to about 300 $cm^2$ $V^{-1}$ $S^{-1}$, and more preferably for some applications greater than or equal to about 800 $cm^2$ $V^{-1}$ $S^{-1}$. Exemplary transistors of the present disclosure exhibiting good electronic performance may have threshold voltages less than about 5 volts and/or on - off ratios greater than about 1 x $10^4$.

"Plastic" refers to any synthetic or naturally occurring material or combination of materials that can be molded or shaped, generally when heated, and hardened into a desired shape. Exemplary plastics useful in the devices and methods of the present disclosure include, but are not limited to, polymers, resins and cellulose derivatives. In the present description, the term plastic is intended to include composite plastic materials comprising one or more plastics with one or more additives, such as structural enhancers, fillers, fibers, plasticizers, stabilizers or additives which may provide desired chemical or physical properties.

"Elastomer" refers to a polymeric material which can be stretched or deformed and return to its original shape without substantial permanent deformation. Elastomers commonly undergo substantially elastic deformations. Exemplary elastomers useful in the present disclosure may comprise, polymers, copolymers, composite materials or mixtures of polymers and copolymers. Elastomeric layer refers to a layer comprising at least one elastomer. Elastomeric layers may also include dopants and other nonelastomeric materials. Elastomers useful in the present disclosure may include, but are not limited to, thermoplastic elastomers, styrenic materials, olefenic materials, polyolefin, polyurethane thermoplastic elastomers, polyamides, synthetic rubbers, PDMS, polybutadiene, polyisobutylene, poly(styrene-butadiene-styrene), polyurethanes, polychloroprene and silicones. Elastomers provide elastomeric stamps useful in the present methods.

"Transfer device" refers to a device or device component capable of receiving and/or relocating an element or array of elements, such as printable semiconductor elements. Transfer devices useful in the present disclosure include conformable transfer devices, having one or more contact surfaces capable of establishing conformal contact with elements undergoing transfer. The present methods and compositions are particularly well suited for use in connection with a transfer device comprising an elastomeric stamp useful for contract printing processing.

"Large area" refers to an area, such as the area of a receiving surface of a substrate used for device fabrication, greater than or equal to about 36 square inches .

"Device field effect mobility" refers to the field effect mobility of an electrical device, such as a transistor, as computed using output current data corresponding to the electrical device.

"Conformal contact" refers to contact established between surfaces, coated surfaces, and/or surfaces having materials deposited thereon which may be useful for transferring, assembling, organizing and integrating structures (such as printable semiconductor elements) on a substrate surface. In one aspect, conformal contact involves a macroscopic adaptation of one or more contact surfaces of a conformable transfer device to the overall shape of a substrate surface or the surface of an object such as a printable semiconductor element. In another aspect, conformal contact involves a microscopic adaptation of one or more contact surfaces of a conformable transfer device to a substrate surface leading to an intimate contact with out voids. The term conformal contact is intended to be consistent with use of this term in the art of soft lithography. Conformal contact may be established between one or more bare contact surfaces of a conformable transfer device and a substrate surface. Alternatively, conformal contact may be established between one or more coated contact surfaces, for example contact surfaces having a transfer material, printable semiconductor element, device component, and/or device deposited thereon, of a conformable transfer device and a substrate surface. Alternatively, conformal contact may be established between one or more bare or coated contact surfaces of a conformable transfer device and a substrate surface coated with a material such as a transfer material, solid photoresist layer, prepolymer layer, liquid, thin film or fluid.

"Placement accuracy" refers to the ability of a transfer method or device to transfer a printable element, such as a printable semiconductor element, to a selected position, either relative to the position of other device components, such as electrodes, or relative to a selected region of a receiving surface. "Good placement" accuracy refers to methods and devices capable of transferring a printable element to a selected position relative to another device or device component or relative to a selected region of a receiving surface with spatial deviations from the absolutely correct position less than or equal to 50 microns, more preferably less than or equal to 20 microns for some applications and even more preferably less than or equal to 5 microns for some applications. The present disclosure provides devices comprising at least one printable element transferred with good placement accuracy.

"Fidelity" refers to a measure of how well a selected pattern of elements, such as a pattern of printable semiconductor elements, is transferred to a receiving surface of a substrate. Good fidelity refers to transfer of a selected pattern of elements wherein the relative positions and orientations of individual elements are preserved during transfer, for example wherein spatial deviations of individual elements from their positions in the selected pattern are less than or equal to 500 nanometers, more preferably less than or equal to 100 nanometers.

"Undercut" refers to a structural configuration wherein the bottom surfaces of an element, such as printable semiconductor element, bridge element or both, are at least partially detached or not fixed from another structure, such as a mother wafer or bulk material. Entirely undercut refers to a refers to a structural configuration wherein the bottom surfaces of an element, such as printable semiconductor element, bridge element or both, is completely detached from another structure, such as a mother wafer or bulk material. Undercut structures may be partially or entirely free standing structures. Undercut structures may be partially or fully supported by another structure, such as a mother wafer or bulk material, that they are detached from. Undercut structures may be attached, affixed and/or connected to another structure, such as a wafer or other bulk material, at surfaces other than the bottom surfaces. For example, the present disclosure includes methods and compositions wherein printable semiconductor elements and/or bridge elements are connected to a wafer at ends positioned on surfaces other than their bottom surfaces (e.g., See Figs. 2A and 2B).

In the following description, numerous specific details of the devices, device components and methods of the present disclosure are set forth in order to provide a thorough explanation of the precise nature of the disclosure. It will be apparent, however, to those of skill in the art that the disclosure can be practiced without these specific details.

This disclosure provides methods and devices for fabricating printable semiconductor elements and assembling printable semiconductor elements and patterns of printable semiconductor elements onto substrate surfaces. Methods for fabricating high quality printable semiconductor elements from low cost bulk semiconductor materials are provided. The present disclosure also provides semiconductor structures and methods providing high precision registered transfer of printable semiconductor elements from a mother wafer to a transfer device and/or receiving substrate. The methods, devices and device components of the present disclosure are capable of generating high performance electronic and optoelectronic devices and arrays of devices on flexible plastic substrates.

Figure 1A provides a schematic cross section view diagram illustrating exemplary methods of the present disclosure for making printable semiconductor elements comprising printable semiconductor ribbons of single crystalline silicon from a bulk silicon wafer having a (111) orientation. Figure 1B provides a flow diagram setting forth processing steps, including repeatable processing steps, in the present methods for generating printable semiconductor elements from bulk silicon wafers.

As shown in Figures 1A (panel 1) and 1B, a silicon wafer having a (111) orientation **100** is provided. Silicon wafer **100** having a (111) orientation may be a bulk silicon wafer. A plurality of channels **110** having preselected physical dimensions, spacing and spatial orientations is etched into external surface **120** of silicon wafer **100,** for example using a combination near field photolithography, lift-off and dry etching techniques. In this aspect of the present disclosure, the spacing **130** between channels defines the width of the printable semiconductor ribbons fabricate using this method.

As shown in Figures 1A (panel 2) and 1B, optionally a thermal oxide layer **140** is grown on channels **110** and external surface **120,** for example by heating the (111) silicon wafer **100**. Next, a mask **150** is deposited on the side surfaces of channels **110** and external surface **120,** for example using angled electron beam evaporation of one or more mask materials such as a metal or combination of metals, thereby generating masked and unmasked regions the silicon wafer **100**. This masking step generates masked regions **160** of the side surfaces and unmasked regions **170** of the side surfaces of channels **110**. The present disclosure includes aspects of the present disclosure wherein the entire side surfaces of channels **110** along depth **135** are masked (See e.g., Fig. 1D). The extent that masked region extend down the side surfaces, in some aspects of the present disclosure, is controlled by angle of evaporation of mask materials, the "shadows" cast by the surface features on external surface **120** of wafer **100** and the degree of collimation of the flux of mask materials . The depth **135** of the trenches **110** and the extent of masked regions **160** of the side surfaces, at least in part, define the thickness of the printable semiconductor ribbon generated by these methods. Optionally, exposed regions of thermal oxide layer 140 is removed prior to additional processing, for example using dry chemical etching techniques.

As shown in Figures 1A (panel 3) and 1B, unmasked regions 170 of the side surfaces of channels 110 are etched. In an exemplary aspect of the present disclosure, unmasked regions 170 of the side surfaces of channels 110 are anisotropically etched such that etching between channels occurs preferentially along <110> directions of the silicon wafer **100,** thereby undercutting regions of (111) silicon wafer **100** between adjacent channels **110**. The direction of the etch front <110> directions is schematically shown by the dashed arrows in panel 3 of Figure 1B. In one aspect of the present disclosure, an anisotropic etching system is chosen so that etching does not substantially occur along <111> directions of the silicon wafer **100**. The selectivity of the anisotropic etching system and the (111) orientation of silicon wafer **100** provides an intrinsic etch stop that is schematically represented as dotted line **175**. Useful anisotropic etching systems for this aspect of the present disclosure include a wet chemical etching system using a hot basic solution. In some aspects of the present disclosure, an etching system is chosen for this processing step that generates a printable semiconductor ribbon having a relatively smooth underside (e.g. roughness less than 1 nanometer).

As shown in Figures 1A (panel 4) and 1B, etching between channels generates printable semiconductor ribbons **200** that are entire undercut from the silicon wafer **100**. In one aspect of the present disclosure, the physical dimensions, shapes and spatial orientations of channels **110** are selected such that the etching processing steps generates printable semiconductor ribbons **200** that are connected at one or more ends to the silicon wafer **100**. Printable semiconductor ribbons **200** generated by the present methods may be flat, thin and mechanically flexible. Optionally, the mask **150** is removed, for example via wet chemical etching techniques.

Referring to the flow diagram in Figure 1B, optionally the present method includes the step of releasing printable semiconductor elements from the silicon wafer, for example by contact with an elastomeric stamp. In exemplary methods, contacting the printable semiconductor elements with an elastomeric stamp fractures one or more bridge elements connecting the printable semiconductor elements to the silicon wafer **100,** thereby resulting in registered transfer of the printable semiconductor element(s) from silicon wafer **100** to the elastomeric stamp. Methods of the present disclosure include use of kinetically controlled peel rates to facilitate register transfer from silicon wafer **100** to an elastomeric stamp transfer device.

Optionally, the present disclosure includes high yield fabrication methods, further comprising the step of refinishing the external surface of the silicon wafer, for example by surface processing steps (e.g., polishing, grinding, etching, micromachining etc.) that generate a flat and/or smooth external surface of silicon wafer 100. As shown in Figure 1B, refinishing silicon wafer **100,** enables the fabrication process to be repeated multiple times, thereby providing high yields of printable semiconductor ribbons from a single silicon wafer starting material.

Figure 1C provides a cross sectional view schematic processing diagram illustrating fabrication methods wherein the side surfaces of recessed features are partially, but not completely, masked. Figure 1D provides a cross sectional view schematic processing diagram illustrating fabrication methods wherein the side surfaces of recessed features are completely masked. As shown in Figure 1D, a portion, but not all, of the floors of the recessed features are also masked. In this aspect of the present disclosure, the method includes the processing step of etching material underneath the masked side surfaces of the recessed feature. The partially masked floor configuration provides an inlet for etchant such that etching may occur between recessed features, such as adjacent recessed features. Methods of the present disclosure employing complete masking of the side surfaces of recessed feature are beneficial for providing enhanced accuracy and precision in the definition and selection of the thickness of the printable semiconductor elements. In one aspect of the present disclosure the side surfaces are completely masked such that the boundary of the passivation happens on the floors of the recessed features. In these methods, the thickness of the ribbon is not defined by the boundary of the passivation, but instead by the height floor the floor of the trenches and the top surface of the wafer.

The methods of fabricating printable semiconductor elements of the present disclosure may further comprise the step of refining the geometry, physical dimensions and morphology of the recessed features. Refining of the recessed features may be carried out at any point in the fabrication process after generation of the recessed features and prior to formation and/or release of the printable semiconductor elements. In a useful aspect of the present disclosure, refining of the recessed features is carried out prior to processing steps involving masking, partially or completely, the side surfaces of the recessed features. Figure 1E provides an image of recessed features in Si (111) having a trench configuration generated without side surface refining. The recessed features shown in Figure 1E were defined by phase shift photolithography, metal lift-off and reactive ion etching, and subsequent removal of metal etch mask. Figure 1F provides an image of recessed features in Si (111) having a trench configuration generated with side surface refining. The recessed features shown in Figure 1F were defined by phase shift photolithography, metal lift-off and reactive ion etching, refining by anisotropic etching in hot KOH solution, and subsequent removal of metal etch mask. This sample is also treated by angled metal evaporation. As shown by a comparison of these figures, the floors and side surfaces of the trenches in Figure 1F are more smoothly defined than the floors and side surfaces of the trenches in Figure 1E.

Refining in this context refers to material removal processing of surfaces of the recessed feature, such as the side surfaces and floors of recessed features. Refining includes processing resulting in smoother recessed feature surfaces and/or processing resulting in recessed features having more uniform physical dimensions and surface morphologies. In one aspect of the present disclosure, the geometry, physical dimensions and/or morphology is refined via anisotropic etching techniques, for example etching using hot KOH solution. Anisotropic wet etch refining of trenches is particularly useful for generation of (111) silicon ribbons capable of register transfer. The advantages of the refining processing steps include: (i) providing improved definition of the trench floors determined from the crystallographic axes of the mother wafer, and (2) providing improved definition of the side surfaces of the trench by the crystallographic axes of the mother wafer.

Figures 2A and 2B provide schematic top plan view diagrams of printable semiconductor structures of the present disclosure comprising a printable semiconductor element and two bridge elements. Bridge elements are positioned distal to each other in the structure shown in Figure 2A and bridge elements are positioned proximal to each other in the structure shown in Figure 2B. A shown in Figures 2A and 2B, printable semiconductor structures **290** comprise printable semiconductor element **300** and bridge elements **310**. Bridge elements **310** are alignment maintenance elements that connect, optionally integrally connect, semiconductor element **300** to mother wafer **320**. In one aspect of the present disclosure, printable semiconductor element **300** and bridge elements **310** are partially or entirely undercut from mother wafer **320**. In one aspect of the present disclosure, printable semiconductor element **300,** bridge elements **310** and mother wafer **320** are a unitary structure, such as a single, continuous semiconductor structure.

Printable semiconductor elements **300** longitudinal extend length **330** along longitudinal axis **340** and extend width **350**. Length **330** terminates in first and second ends **400** that are connected to bridge elements **310**. Bridge elements **310** extend lengths **360** and extend widths **370**. In the aspect of the present disclosure shown in Figures 1A and 1B, bridge elements connect to less than the entire width and/or cross sectional area of the ends **400** of printable semiconductor elements **300**. As shown in Figures 2A and 2B, width **370** of bridge elements **310** is smaller than width **350** of printable semiconductor elements **300** to facilitate registered transfer. In addition, semiconductor elements **300** have surface areas of exposed external surfaces that are larger than the surface areas of exposed external surfaces of bridge elements 310. For some processing and transfer methods of the present disclosure, these dimensional attributes of bridge elements **310** and printable semiconductor elements **300** facilitate high precision registered transfer, assembly and/or integration of printable semiconductor elements **300**

The structural support provided by bridge elements **310** holds semiconductor element **300** in a preselected spatial orientation before and/or during transfer from wafer **320,** for example using an elastomeric stamp transfer device. The anchoring functionality of bridge elements **310** is desirable in many fabrication applications wherein the relative position, spacing and spatial orientation of one or printable semiconductor elements corresponds to a desired functional device and/or circuit design. The physical dimensions, spatial orientation and geometry of bridge elements is selected such that semiconductor elements **300** are capable of release upon contact with a transfer device. In some aspects of the present disclosure release is achieved by fracture, for example along the dotted lines shown in Figures 2B and 2B. It is important for some applications that the force required to fracture the bridge elements **310** is low enough so that the positions and spatial orientations of semiconductor elements **300** are not substantially disrupted during transfer.

The spatial arrangement, geometry, compositions and physical dimensions of bridge elements or any combination of these are selected in the present disclosure to provide high precision registered transfer. Figures 2C and 2D

provide images of bridge elements connecting a printable semiconductor element to a mother wafer. Printable silicon elements and (narrow) bridge elements connecting printable elements to the mother (SOI) wafer are shown in Figure 2C. The geometry of the printable semiconductor element and bridge element is defined by SF6 etching. As shown in Figure 2C, the printable semiconductor element and bridge element confirmation has rounded corners. The roundness of these corners and the overall geometry of these elements decrease the ability to release the printable semiconductor element with a PDMS transfer device. Printable silicon elements and (narrow) bridge elements connecting printable elements to the mother (SOI) wafer are also shown in Figure 2D. Geometry was defined by hot KOH anisotropic etching. As shown in Figure 2D, the printable semiconductor element and bridge element confirmation has sharp corners. The sharpness of those corners concentrates the stress at well defined breaking points and, thus, enhance the ability to release these elements be with a PDMS transfer device.

EXAMPLE 1: Printed Arrays of Aligned GaAs Wires for Flexible Transistors, Diodes, and Circuits on Plastic Substrates

Aligned arrays of GaAs wires with integrated ohmic contacts generated from high-quality, single-crystalline wafers by the use of photolithography and anisotropic chemical etching provide a promising class of material for transistors, Schottky diodes, logic gates and even more complex circuits on flexible plastic substrates. These devices exhibit excellent electronic and mechanical characteristics, which are both important to the emerging area of low cost, large area flexible electronics, often referred to as macroelectronics.

Micron and nanoscale wires, ribbons, platelets, etc. of single crystal inorganic semiconductors are attractive building blocks for functional devices (e.g., optics, optoelectronics, electronics, sensing, etc.) that can be used in many applications. For example, Si nanowires synthesized by "bottom-up" approaches can be assembled using Langmuir/Blodgett techniques (or microfluidics) into aligned arrays and used as transport channels for flexible thin-film transistors (TFTs) on plastic substrates. In a different approach, micro/nanoscale elements of Si (microstructured silicon; $\mu$s-Si) in the form of ribbons with thicknesses of ~100 nm and widths ranging from several microns to hundreds of microns, can be generated from high-quality, single-crystalline bulk sources (e.g., silicon-on-insulator, SOI wafers, or bulk wafers) though "top-down" approaches. This type of material can be used to fabricate flexible TFTs on plastic with device mobilities as high as 300 cm$^2 \cdot$ V$^{-1} \cdot$ s$^{-1}$ . The high quality of the wafer based source material (in terms of well-defined doping levels, uniformity in doping, low surface roughness, and density of surface defects) leads to a silicon based semiconductor material with similarly good properties, which are beneficial for reliable, high performance device operation. The "top-down" fabrication process is attractive also because it offers the possibility of preserving the highly ordered organization nano/microstructures defined at the wafer level, during "dry transfer printing" to the final (e.g. plastic, or other) device substrate. Although high performance is possible with Si, even better characteristics (e.g. operating speed) is achieved with GaAs, for example, due to its high intrinsic electron mobility of ~8500 cm$^2 \cdot$ V$^{-1} \cdot$ s$^{-1}$. Previous studies demonstrate techniques for generating, using anisotropic chemical etching steps, nano/microwires with triangular cross sections from GaAs wafers with "top-down" fabrication steps. By forming ohmic contacts on these GaAs wires while they are still tethered to the wafer, and then transfer printing them to plastic substrates, mechanically flexible metal-semiconductor field-effect transistors (MESFETs) are built with excellent properties. These transistors show unity small signal gains in the gigahertz regime. This example demonstrates the ability to build, with transfer printing as the assembly/integration strategy, various elemental units of functional circuits, such as inverters and logic gates, on plastic substrates using these types of MESFETs as well as GaAs wire based diodes as active components. These types of systems are important in large area electronic circuits for steerable antennas, structural health monitors and other devices that have demanding requirements for high speed, high performance flexible devices on lightweight plastic substrates.

**Fig. 3A** depicts the major steps for fabricating GaAs transistors, diodes and logic gates on plastic. The basic approach relies on "top-down" fabrication techniques to generate micro/nanowires with high purity and well-known doping profiles from bulk single crystal GaAs wafers. Ohmic contacts, formed on the wafer before fabricating the wires, consist of 120 nm AuGe/20 nm Ni/120 nm Au deposited and annealed (450 °C for 1 min in a quartz tube with flowing N$_2$) on an epitaxial layer of 150-nm n-GaAs on a (100) semi-insulating GaAs (SI-GaAs) substrate. The contact stripes lie along the (0 $\overline{1}\,\overline{1}$) crystallographic orientation, and have widths of 2 $\mu$m. In the case of transistors, the gaps between the ohmic stripes define the channel lengths. Photolithography and anisotropic chemical etching generates arrays of GaAs wires with triangular cross sections (inset of **Fig. 3B)** and widths of ~2 $\mu$m, with ends that connect to the wafer **(Fig. 3B).** These connections act as 'anchors' to maintain the well defined orientation and spatial location of the wires, as defined by the layout of etch mask (i.e., photoresist pattern). Removing the etching mask and depositing a bilayer of Ti(2 nm)/SiO$_2$(50 nm) via electron-beam evaporation prepares the surfaces of the wires for transfer printing. The triangular cross section ensures that the Ti/SiO$_2$ films on the surfaces of wires do not connect to those on the mother wafer, thus facilitating the yield of transfer printing. Laminating a slightly oxidized poly(dimethylsiloxane) (PDMS) stamp on the surface of the wafer leads to chemical bonding between the surface of the PDMS stamp and the fresh SiO$_2$ film by a condensation reaction. See top frame of **Fig. 3A.** Peeling back the PDMS stamp pulls the wires off of the wafer and leaves them bound to the stamp. Contacting this 'inked' stamp to a poly(ethylene terephthalate) (PET) sheet coated with a thin layer of liquid polyurethane (PU), curing the PU, peeling off the stamp and then removing the Ti/SiO$_2$ layer in 1:10 HF solution leaves ordered arrays of GaAs wires on the PU/PET substrate, as illustrated in the middle frame of **Fig. 3A.** The Ti/SiO$_2$film not only serves as an adhesive layer to bond the GaAs wires to the PDMS but it also protects the surface of GaAs wires from possible contamination (e.g., by solvents and PU) during the processing.

In this format, the pristine, bare surfaces of the wires and ohmic stripes are exposed for further lithographic processing and metallization to define source and drain electrodes (250 nm Au) that connect the ohmic contacts integrated on the wires. For transistors, these electrodes define the source and drain; for the diodes, they represent the ohmic electrode. Contacts (150 nm Ti/150 nm Au) formed by photolithography and liftoff on the bare parts of the wires while they are integrated with the plastic substrates define Schottky contacts for the diodes and gate electrodes for the MESFETs. All of the processing on the plastic substrate occurs at temperatures below 110 °C. We did not observe any debonding of GaAs wires from the substrates, due to mismatches in thermal expansion coefficients or other possible effects. In the transistors, the width of the gate electrode represents the critical dimension for controlling the operation speed. The position of this electrode between the source and drain is relatively unimportant in this work. This tolerance to poor registration, which is not present in non-self aligned high speed MOSFET (metal-oxide-semiconductor field-effect transistor) type devices, is critically important for reliably achieving high speed operation on plastic substrates where precise registration is often challenging or impossible due to slight uncontrolled deformations that can occur in the plastic during processing. Connecting multiple transistors and diodes together in appropriate geometries generates functional logic circuits. The scheme of **Fig. 3A** shows a NOR gate.

A scanning electron microscope (SEM) image **(Fig. 3C)** shows ten parallel wires that form the semiconductor component of a transistor. The channel length and the gate length of this device are 50 and 5 $\mu$m, respectively. These geometries are used for building the simple integrated circuits, i.e., logic gates. The Ti/Au stripe in the gap between the source and drain electrodes forms a Schottky contact with the n-GaAs surface. This electrode acts as a gate for modulating the flow of current between source and drain. Diodes **(Fig. 3D)** use wires with ohmic stripes on one end and Schottky contacts on the other. **Fig. 3E** and **3F** show images of a collection of GaAs transistors, diodes and simple circuits on a PET substrate. In **Fig. 3F** the PET sheet with circuits is bent around the shaft of a white marker, indicating the flexibility of these electronic units.

The DC characteristics of the wire based MESFETs on plastic **(Fig. 3C)** exhibit qualitatively the same behavior **(Fig. 4A)** as those formed on the wafer. The flow of current between source and drain ($I_{DS}$) is well modulated by the bias applied to the gate ($V_{GS}$), i.e., the $I_{DS}$ decreases with decrease of $V_{GS}$. In this case, the negative $V_{GS}$ depletes the effective carriers (i.e., electrons for n-GaAs) in the channel region and decreases the channel thickness. Once the $V_{GS}$ is negative enough, the depletion layer equals to the thickness of n-GaAs layer and the flow of current between source and drain is pinched off (i.e., the $I_{DS}$ becomes essentially zero). As shown in **Fig. 4A,** the $I_{DS}$ drops to almost zero at the $V_{GS}$ less than -2.5 V. The pinch-off voltage (i.e. gate voltage $V_{GS}$) at a drain-source voltage ($V_{DS}$) of 0.1 V (i.e., linear region) is 2.7 V. In the saturation region ($V_{DS}$ = 4 V), the transfer curve of this transistor is shown in **Fig. 4B.** The ON/OFF current ratio and maximum transconductance are determined from **Fig. 4B** to be ~$10^6$ and ~880 $\mu$S, respectively. The overall source-drain current is a function of the number of wires (i.e., the effective channel width) and the distance between source and drain (i.e., the channel length). With constant channel width, transistors with short channels can provide relatively high currents. For example, the saturated $I_{DS}$ at $V_{GS}$ = 0.5 V and $V_{DS}$ = 4 V increases from 1.75 mA for transistor with channel length of 50 $\mu$m to 3.8 mA for transistor with channel length of 25 $\mu$m **(Fig. 4C).** Although transistors with short channels can supply high current for certain applications, the ON/OFF current ratio tends to decrease because of the difficulty to completely pinch off the current. As shown in **Fig. 4C,** the $I_{DS}$ of transistor with channel length of 25 $\mu$m is still on the order of several microamperes even for $V_{GS}$ of -5 V.

The GaAs-wire Sckottky diodes on plastic exhibit the typical behavior **(Fig. 4D)** of rectifiers, i.e., the forward current ($I$) increases quickly with increasing forward bias voltage (V) while the reverse current remains small even at reverse biases as large as 5 V. The *I-V* characteristics of these Schottky diodes can be described by the thermionic emission model, which is expressed as follows at *V >> 3kT/q:*

$$J \approx J_0 \exp\left(\frac{qV}{nkt}\right) \qquad (1)$$

with

$$J_0 = A^{**}T^2 \exp\left(-\frac{q\phi_B}{kT}\right) \qquad (2)$$

where J represents the forward diode current density with the applied bias voltage (*V*), *k* is the Boltzmann constant, *T* is the absolute temperature (i.e., 298 K in the experiment), $\varphi_B$ is the Schottky barrier height and $A^{**}$ is the effective Richardson constant (i.e., 8.64

A · cm$^{-2}$·K$^{-2}$) for GaAs. By plotting the relationship between In*J* and bias (V) (inset), the saturation current $J_0$ and the ideality factor n are determined from the intercept and slope of the linear relation (the straight line of the inset). The quantity of $\varphi_B$ is estimated with eq. (2). $\varphi_B$ and *n* are commonly used as the evaluation criteria of Schottky interfacial properties. Both are highly dependent on the interface charge states between metal and GaAs, i.e., an increase of charge states will cause the decrease of $\varphi_B$ and the increase of *n* value. For the diodes fabricated in this work, $\varphi_B$ and *n* are determined from the inset of **Fig, 4D** to be 512 meV and 1.21, respectively. These devices have a somewhat lower Schottky barrier (512 meV versus ~800 meV) and larger ideality factor (1.21 versus ~1.10) compared with the diodes built on wafers.

These GaAs-wire devices (i.e., MESFETs and diodes) can be integrated into logic gates for complex circuits. For example, connecting two MESFETs with different channel lengths, which have different saturation currents, forms an inverter (logic NOT gate) **(Fig. 5A** and **5B)**. The load (top) and switching transistor (bottom) have channel lengths of 100 and 50 $\mu$m, respectively, and channel widths of 150 $\mu$m and gate lengths of 5 $\mu$m. This design results in a saturation current from the load transistor that is ~50% that of the switching transistor, which ensures that the load line intersects the $V_{GS}$ = 0 curve of the switching transistor in the linear region with a small turn-on voltage. The inverter is measured in the saturated region, i.e., the $V_{dd}$ is biased with 5 V. When a large negative voltage (logic 0) is applied to the gate of the switching transistor ($V_{in}$) to turn it off, the voltage of the output node ($V_{out}$) equals the $V_{dd}$ (logic 1, high positive voltage) because the load transistor is always on. An increase in $V_{in}$, turns the switching transistor on and provides a large current through both the switching transistor and the load transistor. The $V_{out}$ decreases to a low positive voltage (logic 0) when the switching transistor is completely turned on, i.e., the $V_{in}$ is a large positive voltage (logic 1). **Fig. 5C** shows the transfer curve. The inverter exhibits a maximum voltage gain (i.e., $(dV_{out}/dV_{in})_{max}$ = 1.52) higher than unity. The logic status of $V_{out}$ is shifted to voltages suitable for further circuit integration by adding a level-shifting branch composed of Schottky diodes (as shown in **Fig. 3D).**

Combining several devices of this type in parallel or in series yields more complex logic functions, such as NOR and NAND gates. For the NOA gate shown in **Fig. 6A** and **6B,** two identical MESFETs in parallel serve as the switching transistors. Turning on either switching transistor ($V_A$ or $V_B$) by applying a high positive voltage (logic 1) can provide a large current flow through the drain ($V_{dd}$) of the load transistor to ground (GND), resulting in the output voltage ($V_o$) at a low level (logic 0). High positive output voltage (logic 1) can be achieved only when both inputs are at high negative voltages (logic 0). The dependence of the output on the inputs of the NOR gate is shown in **Fig. 6C.** In the configuration of a NAND gate **(Fig. 6D** and **6E),** the current is large through all transistors only when both switching transistors are turned on by applying high positive voltages (logic 1). The output voltage exhibits a relatively low value (logic 0) in this configuration. Almost no current flows through the transistors with other input combinations, resulting in a high positive output voltage (logic 1), comparable to $V_{dd}$ **(Fig. 6F).** Further integration of logic gates of this type and/or other passive elements (e.g., resistors, capacitors, inductors, etc.) offers the promise for high-speed, large-area electronic systems on plastic.

In summary, GaAs wires with integrated ohmic contacts fabricated using "top-down" procedures with high-quality, bulk single-crystal wafers provide a high performance 'printable' semiconductor material and a relatively easy path to transistors, diodes and integrated logic gates on flexible plastic substrates. The separation of hightemperature processing steps (e.g. formation of ohmic contacts) from the plastic substrates and the use of PDMS stamps for transfer printing well ordered arrays of GaAs wires are key features of the approach described herein. The use of GaAs wires as the semiconductor is attractive for large area printed electronics with demanding requirements on operating speed because (i) GaAs has a high intrinsic electron mobility (~8500 cm$^2$V$^{-1}$s$^{-1}$ ) and has established applications in conventional high frequency circuits, (ii) MESFETs built with GaAs offer simpler processing than MOSFETs because the MESFETs do not require gate dielectrics, (iii) GaAs MESFETs do not suffer from parasitic overlap capacitances that occur in non-self aligned MOSFETs, (iv) high-speed operation in GaAs MESFETs is possible even with the modest levels of patterning registration and resolution that can be achieved easily on large area plastic substrates. The relatively high cost of GaAs (compared with Si) and difficulty to generating complementary circuits with GaAs-wire devices represent drawbacks. Nevertheless, the relative ease with which high performance transistors and diodes that can be built on plastic substrates, and the ability to integrate these components into functional circuits indicates some promise for this path to electronic systems where mechanical flexibility, lightweight construction and compatibility with large area, printing-like processing are required.

Experimental Section: The GaAs wafer (IQE Inc., Bethlehem, PA) has an epitaxial Si-doped n-type GaAs layer (with carrier concentration of 4.0 $\times$ 10$^{17}$ cm$^{-3}$) grown on a (100) semi-insulating GaAs wafer through molecular beam epitaxial (MBE) deposition in a high vacuum chamber. The lithography processes employ AZ photoresist (AZ 5214 and AZ nLOF 2020 for positive and negative imaging, respectively), which are carried out at temperatures (<110 °C) compatible with the plastic substrates, i.e., poly(ethylene terephthalate) (PET of ~175 $\mu$m in thickness, Mylar film, Southwall Technologies, Palo Alto, CA) sheets covered with a thin layer of cured polyurethane (PU, NEA 121, Norland Products Inc., Cranbury, NJ). The GaAs wafers with photoresist mask patterns are anisotropically etched in the etchant (4 mL $H_3PO_4$ (85 wt%), 52 mL $H_2O_2$ (30 wt%), and 48 mL deionized water) that was cooled in the ice-water bath. All the metals are evaporated at a speed of ~4 Å/s by an electron-beam evaporator (Temescal). The evaporation os stopped to cool the samples (for 5 min) to prevent the plastic substrates from melting when 50 nm thick metals are deposited. After the samples are cooled, repeating the evaporation/cooling cycle deposited more metals.

EXAMPLE 2: Gigahertz Operation in Mechanically Flexible Transistors on Flexible Plastic Substrates

The combined use of GaAs wires with ohmic contacts formed from bulk wafers, soft lithographic transfer printing techniques, and optimized device designs enable mechanically flexible transistors to be formed on low cost plastic substrates, with individual device speeds in the gigahertz range and with high degrees of mechanical bendability. The approaches disclosed herein incorporate materials in simple layouts that are fabricated with modest lithographic patterning resolution and registration. This example describes the electrical and mechanical characteristics of high-performance transistors. The results are important in certain applications, including, but not limited to, high-speed communications and computations, and the emerging classes of large area electronic systems ("macroelectronics").

Large area, flexible electronic systems (i.e., macroelectronics) formed with highmobility semiconductors are of interest because some potential applications of these types of circuits require high speed communication and/or computation capabilities. Flexible thin film transistors (TFTs) built with various inorganic materials, such as amorphous/polycrystalline oxides and chalcogenides, polysilicon as well as single crystalline silicon nanowires and microstructured ribbons, exhibit much higher mobilities (10~300 $cm^2 \cdot V^{-1} \cdot S^{-1}$) than those of polycrystalline organic thin films (<1 $cm^2 \cdot V^{-1} \cdot s^{-1}$ in general). Previous work has demonstrated that wire arrays of single crystalline GaAs, which have very high intrinsic electron mobility (~8500 $cm^2 \cdot v^{-1} \cdot s^{-1}$), can serve as transport channels for TFTs in the geometry of metal-semiconductor field-effect transistors (MESFETs). This example shows that with optimized designs, similar devices can operate with frequencies in the GHz regime, even with modest lithographic resolution, and with good bendability. In particular, experimental results show that GaAs wire-based MESFETs on plastic substrates exhibit cutoff frequency higher than 1.5 GHz for transistors with gate length of 2 $\mu$m, with modest changes in the electrical properties for bend radii down to ~1 cm when ~200 mm thick substrates are used. Simple simulations of device behavior agree well with the experimental observations, and operating frequencies in the S-band (5 GHz) are achievable.

The basic fabrication strategy is similar to that described elsewhere, but with optimized device geometries and processing methods to enable high speed operation. GaAs wire (~2 $\mu$m in width) arrays with integrated ohmic stripes (formed by annealing 120 nm AuGe/20 nm Ni/120 nm Au at 450 °C for 1 min in the atmosphere of $N_2$) are fabricated from a (100) semi-insulating GaAs (SI-GaAs) wafer with epitaxial layer of 150-nm n-GaAs through photolithography and anisotropic chemical etching. A thin bilayer of Ti(2 nm)/$SiO_2$(50 nm) is deposited on the undercut GaAs wires to serve as the adhesive layer to facilitate the transfer printing process as well as to protect the flat surfaces of wires and ohmic contacts from contamination by organics (primarily those that transfer from the surfaces of the stamps) involved in the process. This layer is removed by dipping the samples in 1:10 HF solution to expose the clean surfaces of GaAs wires for device fabrication in the sequential steps. In addition, the thin thickness (compared with the thickness of photoresist layers which are used as the adhesive layer for transfer printing in our previous work) of this Ti/$SiO_2$ layer results in a relatively flat surface of plastic poly(ethylene terephthalate) (PET) sheet, on which GaAs wire arrays are printed with the assistance of a spin cast thin layer of polyurethane (PU). The enhanced surface flatness enables deposition of narrow gate electrodes without cracks along their longitudinal direction, thus providing an effective route to increase the operation speed of devices.

The resultant MESFETs on PET substrates (see, SEM image of a typical transistor with gate length of 2 $\mu$m as shown in **Fig. 7A)** exhibit DC transport properties similar to those of transistors built on the mother wafers. **Fig. 7B** shows the current flow between source and drain ($I_{DS}$) as a function of gate voltage ($V_{GS}$) (inset) and as a function of source/drain voltage at different $V_{GS}$, for a device with gate length of 2 $\mu$m. The pinch-off voltage at $V_{DS}$ of 0.1 V (i.e., linear region) is -2.7 V. The ON/OFF current ratio, determined from averaged measurements on many devices, is ~$10^6$. The devices exhibit negligible hysteresis (inset), which is particularly important for high-speed response. The devices show good device-to-device uniformity; Table 1 lists the statistical results (with device number >50) of MESFETs with channel lengths of 50 pm and different gate lengths. The DC characteristics are almost independent of the gate length except that devices with larger gate lengths exhibit somewhat lower ON/OFF ratios. The gate length plays a critical role, however, in determining the operating frequencies as described in the following.

**Table 1** Statistical results of parameters extracted from MESFETs with different gate lengths

| Gate Length (μm) | Channel Resistance (kΩ) | Saturated current (mA) @$V_{GS}$=0 V | Pinch-off Voltage (V) | ON/OFF ratio ($r_{ON/OFF}$)@$V_{DS}$=4V log($r_{ON/OFF}$) | Maximum transconductance (μS) |
|---|---|---|---|---|---|
| 2 | 1.5±0.5 | 1.4±0.5 | -2.41±0.35 | 6.2±0.7 | 796±295 |
| 5 | 1.3±0.2 | 1.6±0.5 | -2.49±0.25 | 6.1±0.5 | 904±337 |
| 10 | 1.5±0.2 | 1.3±0.3 | -2.54±0.14 | 5.8±0.5 | 772±185 |
| 15 | 1.6±0.2 | 1.1±0.2 | -2.69±0.05 | 5.3±0.8 | 749±188 |

*All transistors were formed with 10 parallel GaAs wires and a channel length of 50μm.

The inset of **Fig. 8A** shows the layout of a device designed for microwave testing. Each unit of the test structure contains two identical MESFETs with gate lengths of 2 μm and channel lengths of 50 μm with a common gate, and probing pads configured to match the layout of the RF probes. In the measurement, the drain (D) terminal is held at 4 V (versus source (S)) and the gate (G) is driven by a bias of 0.5 V coupled with a RF power of 0 dBm, which has an equivalently voltage amplitude of 224 mV with 50 Ω. The measurement is carried out using HP8510C Network Analyzer calibrated from 50 MHz to 1 GHz using a standard SOLT (Short-Open-Load-Through) technique on a CascadeMicrotech 101-190B ISS substrate (a piece of ceramic chip covered with laser trimmed gold patterns) through WinCal 3.2 for error corrections. In other words, short calibration is thought to be perfect short and open calibration is thought be perfect open. Since the calibration is done without further de-embedding, the reference plane of measurement is set between the input probe and the output probe. In other words, parasitic components of contact pads are included in the measurement. However, impacts of these parasitic components on contact pads are negligible considering the fact that the wavelength of RF signal with frequency of 1 GHz is 300 mm, whereas length of a contact pad is 200 μm. Since the contact pad is only 1/1500 of the wavelength, its effect of impedance transformation is negligible.

The small-signal current gain ($h_{21}$) can be extracted from the measured S-parameters of the device. This quantity exhibits a logarithmic dependence on the frequency of input RF signal **(Fig. 9A)**. The unity current gain frequency ($f_T$) is defined as the frequency at which the shortcircuit current gain becomes unity. This quantity can be determined by extrapolating the curve of **Fig. 9A** according to a least-square fit of a - 20 dB/decade line and locating its x-intercept. The value determined in this manner is $f_T$=1.55 GHz. This device represents, to our knowledge, the fastest mechanically flexible transistor on plastic and the first with an $f_T$ in the gigahertz regime. We also estimated the RF response of GaAs MESFETs according to the small-signal equivalent circuit model using the measured DC parameters and the calculated capacities between electrodes. The plot from simulation result agrees well with the experimental result yields $f_T$ = 1.68 GHz. This model also works well for the transistors with different gate lengths, for example, the experimental $f_T$ (730 MHz) of MESFET with gate length of 5 μm is close to that simulated quantity (795 MHz) **(Fig. 9B).** In the model, only the intrinsic parameters of MESFET are considered because the extrinsic parameters (i.e., inductance and resistance associated with probing pads) are considered negligible. The transconductance ($g_m$), the output resistance ($R_{DS}$), and the charging resistance ($R_i$, which accounts for the fact that the charge on the channel cannot instantaneously respond to changes in $V_{Ds}$) are extracted from DC measurements. The intrinsic capacitances associated with the MESFET include contributions from the depletion layer, edge fringing and geometric fringing capacitances. Each of these are computed using standard equations for conventional devices with channel widths equal to the summed widths of the individual GaAs wires. The depletion layer capacitance is characterized with the gate length ($L_G$), the effective device width ($W$), and the depletion height:

$$\left( H_{depletion} = \sqrt{\left( \frac{2\varepsilon_r \varepsilon_0}{qN_D} \right)\left( \frac{kT}{q} \right)\left( \ln \frac{N_D}{N_i} - 1 \right)} \right)$$

in the equation:

$$C_{depletion} = \varepsilon_r \varepsilon_0 \frac{L_G W}{H_{depletion}}$$

with an assumption that the depletion layer works as a parallel plate capacitor. The edge fringing capacitance and the geometric fringing capacitance, are determined by:

$$C_{edge} = (\varepsilon_r \varepsilon_0 W)\left(1.41 + \frac{0.86\varepsilon_0}{\varepsilon_r \varepsilon_0}\right)$$

and

$$C_{geometric} = [\varepsilon_r W + \varepsilon_0(150\mu m - W) + 200\mu m]\left(\frac{K(1-k^2)^{1/2}}{K(k)}\right),$$

respectively. 150 $\mu$m and 200 $\mu$m are the width and length of either source or drain pad. $K(k)$ is an elliptical integral of the first kind and

$$k_{DS} = \left[\frac{2(L_S + L_{DS})L_{DS}}{(L_S + L_{DS})^2}\right]^{1/2}$$

and

$$k_{GS} = k_{GD} = \frac{L_{GD}}{L_{GD} + L_G}.$$

$C_{GS}$, capacitance between the gate and the source, include all three kinds of capacitance; while $C_{DS}$ and $C_{DG}$ only contain the edge fringing capacitance and the geometric fringing capacitance. The contributions of $C_{edge}$ and $C_{geometric}$ might be ignored without a significant effect on the simulation results, in most cases, because they are much smaller than $C_{depletion}$, which is appropriate to the gate length. This model accounts for the behavior of the wire array devices on plastic, including the variation in $f_T$ with gate length. **Fig. 8C** compares the measured (symbols) and calculated (dashed line) $f_T$ of GaA-wire MESFETs with different gate lengths and channel length of 50 $\mu$m. This modeling suggests that $f_T$ can be increased significantly by reducing the gate length or by further optimizing the design of the layers in the GaAs mother wafers.

We have reported initial measurements of the effects of tensile strains on wire based MESFETs with gate length of 15 $\mu$m. In this example, we examine the behavior of the high speed devices in both compression and tension, up to the fracture point. The measurements consist of full DC electrical characterization as a function of bending the substrate (see **Fig. 9A**) into concave and convex shapes with different radii of curvature. The bending radii are extracted through geometric fitting of side view images of the bent samples. The convex and concave bend surfaces induce tensile (assigned a positive value) and compressive strain (assigned a negative value) on the devices. A device similar to that shown in the inset of **Fig. 8A** is used to evaluate the effect of bending-induced strain on the performance. The saturation current (i.e., $V_{DS}$ = 4 V, $V_{GS}$ = 0 V) increases by ~10% with increasing tensile strain to 0.71% (corresponding bending radius of 14 mm for the 200-$\mu$m thick substrate used in this work) and drops by -20% with increasing compressive strain to 0.71% **(Fig. 9B)**. The current recovers when the substrate is released after bending in either direction, suggesting that deformations of the plastic substrate and the other components of the devices are elastic in this regime. (The PET and PU are expected to plastically deform at strains > ~2%.) Studies on the strained epilayers of $Ga_xIn_{1-x}As$ or $Ga_xIn_{1-x}As$ on (100) GaAs wafers reveal that biaxial stress as well as externally applied uniaxial stress (the case similar to this example) can cause significant shifts in band-gap energy and valenceband splitting in the epilayers. Tensile strains decrease the band-gap energy thereby increasing the total carrier concentration (electrons and holes) and enhancing the current flow. In contrast, compressive strains increase the band-gap energy and decrease the current flow. These phenomena are consistent with observations of our devices. *In situ* imaging of the bending process with an SEM microscope confirms that none of the GaAs wires break at strains of <+/-0.71 %. At tensile strains above ~1 %, device degradation occurs, due to fracture of some of the wires (or cracking of the gate electrodes). For wires substantially wider than those used here (e.g. 10 $\mu$m widths) the wires debond from the plastic to release the tensile bending stresses, rather than fracture, due to their comparatively high flexural rigidity.

Because the bending strains change the saturated currents by less than 20%, variations in the ON/OFF ratio are determined mainly by changes in the OFF currents. The change of hole concentration in the valence band and the number of dislocations and surface defects of the n-GaAs layer induced by strain might contribute to the variation of the OFF current of the transistor. Both tensile and compressive strains can increase the number of dislocations and surface defects, thus increasing the OFF current of the device. The tensile strain generates additional holes as well as electrons, which also increase the OFF current. Compressive strains, on the other hand, lower the hole concentration. As a result, the OFF current of the MESFET in tension is expected to be higher than that of an unstrained device. The compressive strain has minor effect on the OFF current of the device. The corresponding ON/OFF current ratio, therefore, should decrease with tension and remain approximately the same with compression. **Fig. 9C** gives the dependence of the measured ON/OFF current ratio in the saturation region on strain, showing qualitative agreement with the discussion above.

In summary, the results of this example show that the bending induced surface strain (in both tension and compression, as high as 0.71%) does not significantly degrade the performance of the MESFETs fabricated from the modified procedure. More importantly, releasing the sample in its bent state returns the device performance to its original state. These observations indicate that the GaAs-wire based MESFETs on PU/PET substrates have mechanical properties that meet the requirements of many envisioned applications of macroelectronics. In addition, these types of TFTs exhibit high speeds approaching those suitable for RF communication devices and other applications where mechanical flexibility, lightweight construction and compatibility with large area, printing-like processing are required. Some of the disadvantages of GaAs compared to Si for conventional integrated circuits (i.e. high wafer costs, inability to build reliable complementary circuits, mechanical fragility, etc) have reduced importance for devices that use wires or ribbons in the classes of thin, bendable, moderate density and large-area circuits that are the focus of this work.

EXAMPLE 3: Mechanically Flexible Thin Film Transistors that Use Ultrathin Ribbons of Silicon Derived From Bulk Wafers

This example introduces a type of thin film transistor that uses aligned arrays of thin (sub-micron) ribbons of single crystal silicon created by lithographic patterning and anisotropic etching of bulk silicon (111) wafers. Devices that incorporate such ribbons printed onto thin plastic substrates show good electrical properties and mechanical flexibility. Effective device mobilities, as evaluated in the linear regime, are as high as 360 $cm^2V^{-1}s^{-1}$ , and on/off ratios are $> 10^3$. These results represent important steps toward a low cost approach to large area, high performance, mechanically flexible electronic systems for structural health monitors, sensors, displays and other applications.

Confinement-related properties and broadly useable form factors make lowdimensional materials interesting for new applications in electronics, photonics, microelectromechancial systems and other areas. For example, high-performance flexible electronic devices (e.g. transistors, simple circuit elements, etc.) can be constructed using micro/nanowires, ribbons or tubes that are cast, painted, or printed onto plastic substrates. Thin, high aspect ratio materials structures allow bendability, and, in certain structural forms, stretchability, in single-crystalline semiconductors of materials that are inherently fragile and brittle in bulk. As a result, these types of semiconductors offer intriguing alternatives to vacuum and solution processable poly/noncrystalline organic materials, which usually display significantly lower performance in terms of carrier mobility. Recently described top-down approaches generate semiconductor wires, ribbons, and sheets from wafer based sources of material. This approach provides a high level of control over the geometry, spatial organization, doping levels and materials purity of the resulting structures. The economic attractiveness of this approach, however, especially for applications that demand large area coverage, is limited by the per-area cost of the wafers (silicon on insulator, epitaxial layers on growth substrates, etc).

In this example we report a different approach. In particular, we present a type of thin film transistor (TFT) that uses aligned arrays of silicon ribbons with sub-micron thicknesses derived from low-cost bulk Si (111) wafers. We begin with a description of the procedures for fabricating these structures and transfer printing them onto plastic substrates via elastomeric stamps. We present structural characterization of the shapes of the ribbons, their thicknesses and surface morphologies. Electrical measurements made on Schottky barrier TFTs formed with these printed ribbons exhibit n-type field effect mobilites of 360 $cm^2V^{-1}s^{-1}$ and on/off ratios of 4000.

**Fig. 10** illustrates a top-down method that generates thin (< 1 $\mu$m) ribbons from the surface of a Si (111) wafer (Montco, Inc., n-type, 0.8-1.8 $\Omega$.cm). The process begins with near-field phase shift photolithography[13] followed by metal lift-off and $SF_6$ plasma etching (Plasmatherm RIE system, 40 sccm $SF_6$, 30 mTorr, 200 W RF power for 45 sec.) to produce an array of ~1 $\mu$m deep, 1 $\mu$m wide trenches in the Si surface (Figure 1 (a)). The spacing between the trenches defines the width of the ribbons (generally 10 $\mu$m). Next, 100 nm of thermal oxide is grown on the wafer at 1100°C. Two metal deposition steps, performed by angled electron beam evaporation of Ti/Au (3/30 nm), provide partial coverage of the trench side surfaces **(Fig. 10B)**. The 'shadows' cast during these angled evaporations define the thicknesses of the ribbons. The conditions of the trenching etch, the angle of evaporation and the degree of collimation of the flux of metal control the extent of this shadowing and, therefore, the ribbon thickness. A $CF_4$ plasma etch (40 sccm $CF_4$, 2 sccm $O_2$, 50 mTorr base pressure, 150 W RF power for 5 min) removes exposed oxide. Finally, a hot KOH solution (3:1:1 $H_2O$:KOH:IPA by mass, 100 °C) undercuts the ribbons. The etch front advances in the <110> directions while preserving the (111) planes **(Fig. 10C)** and produces free-standing ribbons that cover a large portion (75-90%) of the original wafer. The etch mask is designed to leave each of the ribbons anchored to the wafer at the ends of the trenches **(Fig. 12A** and 12B). Removing this mask with $KI/I_2$ (2.67/0.67 wt%) in water followed by HF completes the fabrication. Ribbons generated in this manner are thin, flat, and mechanically flexible **(Fig. 10E),** similar to those produced using previously described approaches with expensive silicon-on-insulator wafers.[5-7,11] Atomic force microscopy (Fig. 11A) shows that the thickness ranges from ~115 to ~130 nm across a typical ribbon. These variations show up as slight color variations in optical micrographs **(Fig. 12E).** The roughness as measured by AFM of a 5 x 5 $\mu$m region of the underside of one of these ribbons, displayed in **Fig. 12B,** is 0.5 nm. This value is larger than the top polished surface (0.12 nm) or the underside of a ribbon generated from and SOI wafer (0.18 nm) measured by the same methods. The use of other anisotropic etchants to lower this roughness is of interest. The source of the thickness variations and, to a lesser extent, the roughness, is partly the edge roughness in the trenches, which in turn causes roughness in the side surface passivation during angled evaporation. Improving the side surface quality can reduce the ribbon thickness variations. As we show in the following, however, transistor devices with good performance can be constructed with ribbons fabricated using the procedures described herein.

The ribbons can be transferred to another (flexible) substrate via a high (>95%) yield printing process, as outlined in **Fig. 12.** To perform the printing process, a PDMS stamp is laminated against the wafer and then peeled back quickly to retrieve the ribbons. This type of process relies on kinetic control of adhesion to the stamp. The stamp, thus "inked," **(Fig. 12B** and **12E)** can print the ribbons by contact to another substrate. Ribbons printed onto an ITO-coated 0.2 mm thick PET substrate can be used to make high performance flexible bottom-gate TFTs on plastic with ITO as the gate electrode. A layer of SU-8 deposited onto the ITO gate prior to printing serves as a gate dielectric and a glue to facilitate ribbon transfer. During printing, the ribbons sink into uncured SU-8 such that their tops are flush with the surface of the glue, leaving about 2 $\mu$m of dielectric between the ribbons' bottom surfaces and the ITO. Thick (~0.2 $\mu$m) Ti source and drain contacts defined by photolithography (100 $\mu$m length x 100 $\mu$m width) and wet etching with $HF/H_2O_2$ form Schottky barrier contacts for the source and drain electrodes. These bottom-gate devices display characteristic n-type enhancement mode MOSFET gate-modulation. Transistors achieve on/off ratios of ~103 with devicelevel mobilities, as determined using standard equations for the operation of a metal oxide semiconductor field effect transistors, 14 as high as ~360 $cm^2V^{-1}s^{-1}$ (linear) and 100 $cm^2V^{-1}s^{-1}$ (saturation, evaluated at Vd = 5 V). The mobility of the ribbons themselves should be about 20% higher than the device level mobility (440 $cm^2V^{-1}s^{-1}$ linear and 120 $cm^2V^{-1}s^{-1}$ saturation), since they fill only about 83% of the channel due to the spaces between them. The ribbon devices survive when the substrate is bent to modest (15 mm) radii but degrade seriously at sharper (5 mm) bends for the 0.2 mm thick substrates.

In summary, this example demonstrates a high-yield fabrication strategy for producing printable single-crystal silicon ribbons from a bulk silicon (111) wafer. Refinishing the bulk wafer's surface after fabrication permit multiple repetitions, producing tens or even hundreds of square feet of ribbons from one square foot of starting material. TFTs made from these ribbons on plastic demonstrate their use as high-performance flexible semiconductors. These devices and the strategies to fabricate them are useful not only for large area flexible electronics, but also for applications that require three dimensional or heterogeneous integration or other features that are difficult to achieve using conventional silicon microfabrication approaches.

EXAMPLE 4: Bendable GaN High Electron Mobility Transistors (HEMTs) on Plastic Substrates

Flexible and large area electronics, technologies embraced within the emerging field of Macroelectronics, has witnessed remarkable progress over the past several years, with several leading consumer and military applications expected to be commercialized in the near future. Microelectronic circuits with novel form factors are critical components of these systems and new methods of fabrication - especially printing - will likely be needed to manufacture them. For this reason, considerable attention has been given to printable forms of semiconductors, and both organic (e.g. pentacene, polythiophenes, etc.) and inorganic (such as poly silicon, inorganic nanowires) materials have been examined. This work has shown some promising results for devices integrated on plastic substrates. Their current range of application, however, is one that is largely limited by the innate poor performance of devices made from these semiconductors, such as their low effective device mobilities and frequencies of operation. We have examined a new form of printable inorganic semiconductors, called microstructured semiconductors ($\mu$s-Sc) that enables the fabrication of exceptionally high performance devices on both conventional and organic polymer substrate. We have also shown that, using $\mu$s-Sc as a basis, fully developed devices can be made on semiconductor wafers and then subsequently transferred to a flexible substrate without diminishing their performance. This approach exploits the high quality of wafer scale semiconductors, while rendering them amenable to printing based methods of fabrication. Among these materials, single crystalline $\mu$s-GaN is of great interest, as it has superior material properties that include a wide band gap (3.4 eV vs 1.4 eV of GaAs) leading to high breakdown field (3 MV $cm^{-1}$ vs 0.4 MV $cm^{-1}$ of GaAs), high saturation carrier velocity (2.5*$10^7$ cm $S^{-1}$ vs $10^7$ cm $S^{-1}$ of GaAs), and good thermal conductivity (1.3 W $cm^{-1}$ vs 0.5 W $cm^{-1}$ of GaAs). In addition, the heterogeneous integration in the form of AlGaN/GaN heterostructures yields device grade materials with a high conduction band offset and piezoelectric responsiveness with sheet carrier densities lying in the $1.0 \times 10^{13}$ cm$^{-2}$ range. These attractive properties made GaN suitable for requiring both high frequency and high power performance, such as electronic devices for wireless communication, full color light emitting devices, and UV photodetectors for optoelectronic systems.

Since the first demonstration of an AlGaN/GaN high electron mobility transistors (HEMTs), there has been substantial research activity focused in this area. These efforts have led to devices being integrated on a variety of substrates, including sapphire, SiC, Si and AIN. In this example, we describe the fabrication of flexible AlGaN/GaN heterostructure high electron mobility transistors (HEMTs, as shown the process summarized in **Fig. 14),** ones processed and subsequently transferred from their Si (111) growth substrate onto plastic sheets via a contact-printing-based protocol. This work provides a description of procedures for integrating high performance HEMT devices based on heterostructure III-V semiconductor materials onto plastic substrates.

**Fig. 15** schematically illustrates the steps used in the fabrication of the HEMT devices. The process starts with the formation of an ohmic contact (Ti/Al/Mo/Au) on the bulk GaN heterostructure wafer using a standard sequence photolithographic and lift-off steps **(Fig. 15A).** A PECVD oxide layer and Cr metal are then deposited to serve as a mask for subsequent dry etching. Photolithography and etching of the Cr and PECVD oxide define the geometries desired for GaN ribbons that serve as the solid ink for subsequent printing **(Fig. 15B).** After striping the top photoresist, ICP dry etching is used to remove the exposed GaN **(Fig. 15C).** The Cr layer is removed by this ICP etching step, but left the thicker PECVD oxide layer essentially intact on top of the GaN. Anisotropic wet etching with tetramethyl ammonium hydroxide (TMAH) **(Fig. 15D)** removes the underlying Si and detaches the GaN ribbons from the mother substrate. During this strong alkaline etching, the PECVD oxide serves to protect the ohmic contacts from degradation. The remaining PECVD oxide, which has been severely roughened by the plasma and wet etching steps, is then removed using a BOE (buffered oxide etchant) process step. A new smooth, sacrificial silicon oxide layer is deposited subsequently on the top of GaN ribbons by e-beam evaporation. A print to GaN ribbons, the wafer was contacted with a poly-dimethylsiloxane (PDMS) slab **(Fig. 15E),** and on fast removal from the mother substrate, a complete transfer of the $\mu$s-GaN to the PDMS is obtained. This "inked" slab is then laminated with a poly(ethyleneterepthalate) sheet (PET) coated with polyurethane (PU) **(Fig. 15F)** and, from the topside, a UV light is used to cure the PU **(Fig. 15H).** Peeling back the PDMS results in the transfer of the $\mu$s-GaN elements to the plastic substrate. The transfer leaves a PU residue on top of GaN ribbons. This residue is removed when the e-beam-deposited SiO$_2$ layer, evaporated in the step of **Fig. 15E,** is stripped with BOE. The final step of the process involves the formation of source/drain interconnections and schottky gate metal contacts (Ni/Au), layers deposited by e-beam evaporation and patterned using a standard liftoff process **(Fig. 15F).**

To maintain the original position of the freestanding $\mu$s-GaN after removing underlying Si (Figure 1d), we adopt new geometry of microstructured semiconductor ($\mu$s-Sc) as shown in the process outlined in **Fig. 14C.** The $\mu$s-GaN ribbon has two narrow bridges (i.e. two breaking points as indicated as arrows in **Fig. 14C)** at the ends of the GaN ribbon to facilitate their registered transfer to the PDMS printing tool **(Fig. 15E).** This architecture represents a significant improvement over the 'peanut' design reported previously. The fracture that mediates the transfer process was found to be vastly efficient with this design. The earlier 'peanut' design requires a strict optimization of etching time and highly uniform etch rates over a large area to generate $\mu$s-Sc ribbons suitable for printing. T he current 'narrow bridge' design is far less sensitive to etching rate difference. To illustrate this latter point, **Fig. 16A** and **16B** show optical images of the GaN wafer taken before and after TMAH anisotropic etching step, respectively. The different colors of the freestanding and supported GaN microstructure are easily distinguishable in these images. **Fig. 16C** and **16D** show scanning electron micrograph (SEM) images taken at intermediate stages of the TMAH etching step that cuts the underlying Si. The magnified image of **Fig. 16D** and dashed line area of **Fig. 16B** powerfully illustrate the highly anisotropic nature of this indicate that Si etching process, one propagated essentially only in a direction perpendicular to the orientation of the GaN ribbon. In this particular system, the preferential etching occurs along the (110) direction; the Si (111) surfaces, as noted in **Fig. 14C,** served as an innate etch blocking mask. **Fig. 16E** shows an SEM image of an inked PDMS slab where the $\mu$s-GaN was transferred with full tension of its on-wafer registration. The image of **Fig. 16F** shows an SEM micrograph of the printed structures where, the final step, the $\mu$s-GaN heterostructure devices are transferred to the PU coated PET substrate. These images demonstrate that transfer based on the 'narrow bridge' $\mu$s-GaN motif does not damage heterostructure ribbons.

**Fig. 17A** and **17B** present representative optical images of $\mu$s-GaN based HEMTs after transfer to the PET substrate. The various contrast correspond to the various lends of the cross section schematic of these devices is shown in **Fig. 14B.** In this geometry, the active electron channel is formed between the two ohmic contacts (Ti/Al/Mo/Au) and the electron flow rate (or current) is controlled by the schottky (Ni/Au) gate contact. The channel length, the channel width, and the gate width of the devices shown in **Fig. 17B** are 20, 170, and 5 $\mu$m respectively. Unlike previous $\mu$s-GaAs processes that had inevitable limitation of small filling factor caused by side surface wet etching, the filling factor for these devices is quite high compared to an earlier report for a printed III-V structure (67% vs 13% for $\mu$s-GaAs). **Fig. 17C** shows typical drain current -voltage (I-V) characteristics of the plastic supported GaN HEMT devices; the gate was biased from -3 to 1 V in steps of 1 V. The device exhibits a maximum drain current of ~5 mA at a gate bias of 1 V and drain bias of 5 V. **Fig. 17D** shows the transfer characteristics, measured at a constant drain voltage ($V_d$ = 2 V). The device exhibits threshold voltage ($V_{th}$) of -2.7 V, an on/off ratio of $10^3$, and a transconductance of 1.5 mS. The transconductance of GaN HEMTs with the same device geometry but prior to transfer has a transconductance of 2.6 mS. The transfer process appears to lead to reduction in this value of about 38%.

The mechanical flexibility of the GaN HEMTs was investigated using a bending stage, as shown in **Fig. 18A.** **Fig. 18B** shows a series of transfer curves measured as a function of bending radius (and its corresponding strain). For bending radii down to 1.1 cm (corresponding to strains of the order of 0.46 %), we observe very stable responses in the measured transconductance, threshold voltage, and on/off ratios. **Fig. 18C** shows a sequence of current-voltage (I-V) curves measured at both the positions of maximum strain and after its release. As noted above, the impacts found are relatively modest and the small differences seen between three I-V curves of **Fig. 17B** and **Fig. 18B** suggest that the μs-GaN HEMT devices are not damaged by the harsh bending cycles.

In summary, this example describes a process suitable for printing high performance GaN HEMTs in flexible forms on plastic substrates. We further demonstrate an efficient geometry of μs-Sc that facilitates transfer printing protocols, and smart-material strategies for removing sacrificial layers by anisotropic wet etching. Our results suggest that μs-GaN technology provide interesting opportunities for developing next generation macroelectronic devices, such as high performance mobile computing and high speed communication systems.

Methods: GaN microstructures are fabricated on a heterostructure GaN on silicon (100) wafer (Nitronex) comprised of three layers of III-V semiconductor: AlGaN layer (18 nm, undoped); GaN buffer layer (0.6 μm, undoped); and AlN transition layer (0.6 μm). Using AZ 5214 photoresist, an ohmic contact area is opened and this exposed area is cleaned using an $O_2$ plasma (Plasmatherm, 50 mTorr, 20 sccm, 300 W, 30 sec). In order to achieve low contact resistances, a pretreatment of the ohmic contact area using a $SiCl_4$ plasma in a RIE system is performed prior to the metallization step. A Ti/Al/Mo/Au (15/60/35/50 nm from bottom to top) metal layer is then deposited. Electron-beam evaporation is used to deposit Ti, Al, and Mo, while Au was deposited by thermal evaporation. The contacts are defined using a lift-off process. The contacts are annealed at 850 °C for 30 sec in a rapid thermal annealing system using an $N_2$ ambient. The PECVD oxide (Plasmatherm, 400 nm, 900 mTorr, 350 sccm 2% $SiH_4$/He, 795 sccm $NO_2$, 250 °C) and Cr metal (E-beam evaporator, 150 nm) layers are deposited as the mask materials for subsequent ICP etching. Photolithography, wet etching (Cyantek Cr etchant) and RIE processing (50 mTorr, 40 sccm $CF_4$, 100 W, 14 min) define the ribbon geometries of the GaN. After removing the photoresist with acetone, ICP dry etching (3.2 mTorr, 15 sccm $Cl_2$, 5 sccm Ar, -100V Bias, 14 min) is used to remove the exposed GaN, and the underlying Si is then etched away using a TMAH wet etching solution (Aldrich, 160 °C for 5 min). The sample is dipped in BOE (6:1, $NH_4F$: HF) for 90 sec to remove the PECVD oxide and a new 50 nm e-beam evaporated $SiO_2$ layer deposited on top of the GaN ribbons. The GaN wafer is then contacted with a PDMS slab (Sylgard 184, Dow corning) which is then pealed away at peel rate > 0.01 m s$^{-1}$ to pick up the μs-GaN elements. The PDMS slab inked with the μs-GaN is then laminated to a poly(ethyleneterepthalate) sheet (PET, 100 μm in thickness, Glafix Plastics) coated with polyurethane (PU, Norland optical adhesive, No. 73). The sample is exposed to UV light (home-built ozone active mercury lamp, 173 μW cm$^{-2}$) from the top to cure the PU. Peeling back the PDMS and removing the e-beam oxide by immersion in BOE for 30 sec results in the transfer of the μs-GaN elements onto the plastic substrate. A negative photoresist (AZ nLOF2020) is used to pattern the Schottky contact area and a Ni/Au (80/100 nm) layer is then deposited by ebeam evaporation. The PR is removed using a lift off process in conjunction with an AZ stripper (KWIK for 5 hours).

EXAMPLE 5: Printable Semiconductor Elements Derived from Bulk Wafer of GaAs with Multiple Epitaxial Layers.

The present disclosure includes methods of making printable semiconductor ribbons using bulk wafers of GaAs as starting materials. In one aspect of the present disclosure, the ribbons are generated from a high-quality bulk wafer of GaAs with multiple epitaxial layers. The wafer is prepared by growing a 200-nm thick AlAs layer on a (100) semi-insulating GaAs (SI-GaAs) wafer, followed by sequential deposition of a SI-GaAs layer with thickness of 150 nm and Si-doped n-type GaAs layer with thickness of 120 nm and carrier concentration of 4x$10^{17}$ cm$^{-3}$. A pattern of photoresist lines defined parallel to the (0 $\bar{1}$ $\bar{1}$) crystalline orientation serves as masks for chemical etching of the epilayers (including both GaAs and AlAs). Anisotropic etching with an aqueous etchant of $H_3PO_4$ and $H_2O_2$ isolated these top layers into individual bars with lengths and orientations defined by the photoresist, and with side surfaces that form acute angles relative to the wafer surface. Removing the photoresist after the anisotropic etching and then soaking the wafer in an ethanol solution of HF (2:1 in volume between ethanol and 49% aqueous HF) removes the AlAs layer and released ribbons of GaAs (n-GaAs/SI-GaAs). The use of ethanol, instead of water, for this step reduces cracking that can occur in the fragile ribbons due to the action of capillary forces during drying. The lower surface tension of ethanol compared to water also minimizes drying-induced disorder in the spatial layout of the GaAs ribbons.

GaAs wafers with customer-designed epitaxial layers are purchased from IQE Inc., Bethlehem, PA. The lithographic processes employed AZ photoresist, i.e., AZ 5214 and AZ nLOF 2020 for positive and negative imaging, respectively. The GaAs wafers with photoresist mask patterns are anisotropically etched in the etchant (4 mL $H_3PO_4$ (85

wt%), 52 mL $H_2O_2$ (30 wt%), and 48 mL deionized water) that is cooled in the ice-water bath. The AlAs layers are dissolved with a diluted HF solution (Fisher® Chemicals) in ethanol (1:2 in volume). The samples with released ribbons on mother wafers are dried in a fume hood. The dried samples are placed in the chamber of electron-beam evaporator (Temescal FC-1800) and coated with sequential layers of 2-nm Ti and 28-nm $SiO_2$.

EXAMPLE 6: Multi-layer Arrays Printable Semiconductor Elements Derived from Si (111) Wafers.

The present disclosure also includes methods and compositions providing multilayer arrays printable semiconductor elements derived from Si(111) wafer precursor materials. Figure 19 provides a process flow schematic illustrating a method of the present disclosure for making multilayer arrays of printable semiconductor elements. As shown in panel 1 of figure 19, a silicon wafer having a (111) orientation is provided. An external surface of the wafer is patterned with an etch resistant mask, thereby generating masked regions having dimensions selected to define the lengths and widths of printable semiconductor ribbon in the multilayer array. In the example shown in Figure 19, the etch resistant mask is a thermally grown $SiO_2$ layer.

As shown in pane 2, the silicon wafer is etched predominately in a directed orthogonal to the patterned external surface. The etching system employed generates recessed features having contoured side surfaces. In a useful aspect of the present disclosure, the side surfaces of the recessed features have a selected, spatially varying contour profile having a plurality of contour features, such as side surfaces with a periodic scalloped contour profile and/or a contour profile having deep ridges present on the side surfaces of the recessed features. Exemplary means for generating recessed features having a selected contour profile include STS-ICPRIE and BOE etching systems providing cyclic exposure of the silicon wafer to reactive ion etchant gases and etch resist materials. As shown in panel 3 of figure 19, this processing step generates a plurality of silicon structures having selectively contoured side surfaces positioned adjacent to the recessed features.

As shown in panel 3 of figure 19, the processed silicon wafer having recessed features and silicon structure is subject to deposition of an etch resistant mask materials such that the contoured side surfaces of the recessed features is only partially coated with deposition material. In this aspect of the disclosure the selected contour profile of the side surfaces of the recessed features determines, at least in part, the spatial distribution of mask material on the side surfaces. This processing step, therefore, defines the thickness of printable semiconductor elements in the multi layer stack. For example, the wafer may be exposed to angled vapor deposition of a metal or combination of metals resulting in deposition of material predominately on ridges present in the contoured surfaces of the recessed features and substantially no deposition on regions of the contoured surface that are in the "shadows" of the ridges present for example to recessed regions of the side walls. The "shadows" casts by features in the selected contour profile, such as ridges, ripples and scalloped shaped features, therefore, at least in part define the thickness of the printable semiconductor elements in the multilayer array. Use of gold deposition materials is beneficial due to its good adherence to the exposed silicon surface.

As shown in panel 4 of figure 19, the wafer is next subjected to anisotropic etching, for example via exposure to a basic solution such as KOH. Regions between the recessed features are etched such that etching occurs along <110> directions of the silicon wafer, thereby fabricating a multilayer array of printable semiconductor elements each of which comprising a partially or entirely undercut silicon structures. The present disclosure includes methods wherein etching along <110> directions of the silicon wafer proceeds to completion between adjacent recessed features, thereby entirely undercutting the printable semiconductor element(s). As described in detail above, the etching system chosen in combination with the (111) orientation of the silicon wafer results in a faster etch rate along <110> directions than along <111> directions of the wafer. Optionally, the position, shape and spatial orientation of recessed features are selected to form alignment maintenance elements, such as bridge elements connecting the printable semiconductor element to the wafer. In the multilayer structure shown in panel 4, bridge elements are provided that connect the ends of the semiconductor ribbons in the multilayer array to the silicon wafer.

Panel 5 of figure 19 shows an optional processing step wherein the bridge elements are released from the silicon wafer, for example via washing, etching or other material removal processes, thereby generating a multilayer stack of printable semiconductor elements. Alternatively, printable semiconductor elements in the array can be released via contact printing methods. In one aspect of the present disclosure, for example, printable semiconductor elements in the multilayer array are sequentially released and transferred from the silicon wafer via repeatedly bringing the printable semiconductor elements in contact with a transfer device, such as an elastomeric stamp.

Figure 20 provides SEM images of Si (111) in angled-view (a, c, e, g) and cross-sectional view (b, d, f, h): (a and b) after STS-ICPRIE and BOE etching, (c and d) after metal protection on the side surfaces, (e through h) after KOH etching for 2 min (e and f) and 5 min (g and h) followed by metal cleaning.

Figure 21 provides (a) provides a photograph of a large-scale aligned array of four-layered Si (111) ribbons. (b and c) Top-view and (d and e) angled-view SEM images of the four-layered Si (111) shown in (a).

Figure 22 provides (a) Photograph and (b and c) OM images of released flexible Si (111) ribbons. (d to f) SEM images of the ribbons shown in (a).

Figure 23 provides (a) Optical images of aligned Si (111) ribbons transferred on PDMS substrate. (b) AFM image of four ribbons from the array shown in (a). Photograph of a flexible polyester film that houses four patterns of Si (111) arrays from four cycles of transferring from a single Si chip.

**REFERENCES**

[1] a) Y. Xia, P. Yang, Y. Sun, Y. Wu, B. Mayers, B. Gates, Y. Yin, F. Kim, H. Yan, Adv. Mater. 2003, 15, 353. b) C. M. Lieber, Mater. Res. Soc. Bull. 2003, 28, 486. c) M. C. McAlpine, R. S. Friedman, C. M. Lieber, Proc. IEEE 2005, 93, 1357. d) M. Law, J. Goldberger, P. Yang, Ann. Rev. Mater. Res. 2004, 34, 83. e) P. Yang, Mater. Res. Soc. Bull. 2005, 30, 85. f) Z. R. Dai, Z. W. Pan, Z. L. Wang, Adv. Funct. Mater. 2003, 13, 9. g) special issue on nanostructured advanced materials, Pure Appl. Chem. 2002, 74(9).
[2] a) Y. Yin, A. P. Alivisatos, Nature, 2005, 437, 664. b) I. Gur, N. A. Fromer, M. L. Geier, A. P. Alivisatos, Science, 2005, 310, 462. c) L. Samuelson, M. T. Björk, K. Depper, M. Larsson, B. J. Ohlsson, N. Panev, A. I. Persson, N. Sköld, C. Thelander, L. R. Wallenberg, Physica E 2004, 21, 560.
[3] a) L. A. Bauer, N. S. Birenbaum, G. J. Meyer, J. Mater. Chem. 2004, 14, 517. b) Y. Cui, Q. Wei, H. Park, C. M. Lieber, Science 2001, 293, 1289.
[4] Z. Tang, N. A. Kotov, Adv. Mater. 2005, 17, 951.
[5] X. Duan, C. Niu, V. Sahi, J. Chen, J. W. Parce, S. Empedocles, J. L. Goldman, Nature 2003, 425, 274.
[6] R. S. Friedman, M. C. McAlpine, D. S. Ricketts, D. Ham, C. M. Lieber, Nature 2005, 434, 1085.
[7] E. Menard, K. J. Lee, D.-Y. Khang, R. G. Nuzzo, J. A. Rogers, Appl. Phys. Lett. 2004, 84, 5398.
[8] a) S. Mack, M. A. Meitl, A. Baca, in preparation. b) Y. Sun, S. Mack, J. A. Rogers, Proc. Intl. Electron Device Meeting (IEEE), 2005, in press.
[9] a) E. Menard, R. G. Nuzzo, J. A. Rogers, Appl. Phys. Lett. 2005, 86, 093507. b) Z.-T. Zhu, E. Menard, K. Hurley, R. G. Nuzzo, J. A. Rogers, Appl. Phys. Lett. 2005, 86, 133507.
[10] a) Y. Sun, J. A. Rogers, Nano Lett. 2004, 4, 1953. b) Y. Sun, D.-Y. Khang, F. Hua, K. Hurley, R. G. Nuzzo, J. A. Rogers, Adv. Funct. Mater. 2005, 15, 30.
[11] Y. Sun, S. Kim, I. Adesida, J. A. Rogers, Appl. Phys. Lett. 2005, 87, 083501.
[12] Y. Sun, H.-S. Kim, E. Menard, S. Kim, G. Chen, I. Adesida, R. Dettmer, R. Cortez, A. Tewksbury, J. A. Rogers, Appl. Phys. Lett., submitted.
[13] R. H. Reuss, B. R. Chalamala, A. Moussessian, M. G. Kane, A. Kumar, D. C. Zhang, J. A. Rogers, M. Hatalis, D. Temple, G. Moddel, B. J. Eliasson, M. J. Estes, J. Kunze, E. S. Handy, E. S. Harmon, D. B. Salzman, J. M. Woodall, M. A. Alam, J. Y. Murthy, S. C. Jacobsen, M. Olivier, D. Markus, P. M. Campbell, E. Snow, Proc. IEEE 2005, 39, 1239.
[14] D. C. Duffy, C. McDonald, O. J. A. Schueller, G. M. Whitesides, Anal. Chem. 1998, 70, 4974.
[15] S. M. Sze, Semiconductor Devices, Physics and Technology (Wiley, New York, 1985).
[16] G. Eftekhari, Phys. Status Solidi A-Appl. Res. 1993, 140, 189.
[17] H.-I. Chen, C.-K. Hsiung, Y.-I Chou, Semicond. Sci. Technol. 2003, 18, 620.
[18] S. Forment, M. Biber, R. L. van Meirhaeghe, W. P. Leroy, A. Türüt, Semicond. Sci. Technol. 2004, 19, 1391.
[19] L. Stephen, S. E. Butner, Gallium Arsenide Digital Intergrated Circuit Design. (McGraw-Hill, New York, 1990).

1R. H. Reuss, B. R. Chalamala, A. Moussessian, M. G. Kane, A. Kumar, D. C. Zhang, J. A. Rogers, M. Hatalis, D. Temple, G. Moddel, B. J. Eliasson, M. J. Estes, J. Kunze, E. S. Handy, E. S. Harmon, D. B. Salzman, J. M. Woodall, M. A. Alam, J. Y. Murthy, S. C. Jacobsen, M. Olivier, D. Markus, P. M. Campbell, and E. Snow, Proc. IEEE 39, 1239 (2005).
2K. Nomura, H. Ohta, A. Takagi, T. Kamiya, M. Hirano, and H. Hosono, Nature 432, 488 (2004).
3D. B. Mitzi, L. L. Kosbar, C. E. Murray, M. Copel, and A. Afzali, Nature 428, 299 (2004).
4S. Ucjikoga, MRS Bull. 27, 881 (2002).
5X. Duang, C. Niu, V. Sahi, J. Chen, J. W. Parce, S. Empedocles, and J. L. Goldman, Nature 425, 274 (2003).
6R. S. Friedman, M. C. McAlpine, D. S. Ricketts, D. Ham, and C. M. Lieber, Nature 434, 1085 (2005).
7E. Menard, K. J. Lee, D.-Y. Khang, R. G. Nuzzo, and J. A. Rogers, Appl. Phys. Lett. 84, 5398 (2004).
8E. Menard, R. G. Nuzzo, and J. A. Rogers, Appl. Phys. Lett. 86, 093507 (2005).
9Z.-T. Zhu, E. Menard, K. Hurley, R. G. Nuzzo, and J. A. Rogers, Appl. Phys. Lett. 86, 133507 (2005).
10Y. Sun, S. Kim, I. Adesida, and J. A. Rogers, Appl. Phys. Lett. 87, 083501 (2005).
11Y. Sun, and J. A. Rogers, J. A. Nano Lett. 4, 1953 (2004).
12Y. Sun, D.-Y. Khang, F. Hua, K. Hurley, R. G. Nuzzo, and J. A. Rogers, Adv. Funct. Mater. 15, 30 (2005).
13A. S. Sedra, and K. C. Smith, Microelectronic Circuits (Oxford University Press, New York, 1998).

14L. Stephen, and S. E. Butner, Gallium Arsenide Digital Intergrated Circuit Design (McGraw-Hill, New York, 1990).

15M. C, Lau, Small Signal Equivalent Circuit Extraction from a Gallium Arsenide MESFET device (M.S. thesis, Virginia Polytechnic Institution and State University, Blacksburg, VA, 1997).

16L. B. Freund, Intl. J. Solids Struct. 37, 185 (2000).

17C. P. Kuo, S. K. Vong, R. M. Cohen, and G. B. Stringfellow, J. Appl. Phys. 57, 5428 (1985).

1X. Duan, C. Niu, V. Sahi, J. Chen, J. W. Parce, S. Empedocles, J. L. Goldman, Nature 425, 274 (2003).

2Y. Huang, X. Duan, Q. Wei, C. M. Lieber, Science 291, 630 (2001).

3 M. A. Meitl, Y. Zhou, A. Gaur, S. Jeon, M. L. Usrey, M. S. Strano, J. A. Rogers, Nano Lett. 4, No. 9 1643 (2004).

4R. S. Friedman, Nature 434, 1085 (2005).

5E. Menard, K. J. Lee, D.-Y. Khang, R. G. Nuzzo and J. A. Rogers, Appl. Phys. Lett. 84, 5398 (2004).

6E. Menard, R.G. Nuzzo and J.A. Rogers, Appl. Phys. Lett. 86, (2005).

7Z.-T. Zhu, E. Menard, K. Hurley, R. G. Nuzzo, J. A. Rogers, Appl. Phys. Lett. 86, 133507 (2005).

8Y. Sun, S. Kim, I. Adesida, J. A. Rogers, Appl. Phys. Lett. 87, 083501 (2005).

9K. J. Lee, M. J. Motala, M. A. Meitl, W. R. Childs, E. Menard, A. K. Shim, J. A. Rogers, R. G. Nuzzo, Adv. Mater. 17, 2332 (2005).

10 M. A. Meitl, Z.-T. Zhu, V. Kumar, K. J. Lee, X. Feng, Y. Y. Huang, I. Adesida, R. G. Nuzzo, and J. A. Rogers, Nat. Mater. 5, 33 (2006).

11D.Y. Khang, H. Jiang, Y. Huang and J.A. Rogers, Science 311, 208 (2006).

12S. R. Forrest, Nature 428, 911 (2004).

13J. A. Rogers, K. E. Paul, R. J. Jackman, G. M. Whitesides, Appl. Phys. Lett. 70, 2658 (1997).

14S. Sze., Semiconductor Devices: Physics and Technology 2nd ed. (Wiley, New York, 2002), pp. 190-192.

[1] R. Reuss et al. Proc. IEEE. 2005, 39, 1239.

[2] J. A. Rogers, Z. Bao, K. Baldwin, A. Dodabalapur, B. Crone, V. R. Raju, V. Kuck, H. Katz, K. Amundson, J. Ewing, P. Drzaic, Proc. Nat. Acad. Sci. 2001, 98, 4835.

[3] (a) J. H. Schön, S. Berg, C. Kloc, B. Batlogg, Science 2000, 287, 1022. (b) A. Dodabalapur, L. Torsi, H. E. Katz, Science 1995, 268, 270.

[4] B. S. Ong, Y. Wu, P. Liu, S. Gardner, J. Am. Chem. Soc. 2004, 126, 3378.

[5] S. R. Forrest, Nature, 2004, 428, 911.

[6] C. R. Kagan, D. B. Mitzi, C. D. Dimitrakopoulos, Science 1999, 286, 945.

[7] X. Duan, C. Niu, V. Sahi, J. Chen, J. W. Parce, S. Empedocles, J. L. Goldman, Nature, 2003, 425, 274.

[8] J. Kwon, D. Kim, H. Cho, K. Park, J. Jung, J. Kim, Y. Park, T. Noguchi, IEEE Trans. Electron. 2005, 466, 7.

[9] K. Lee, M. J. Motala, M. A. Meitl, W. R. Childs, E. Menard, A. K. Shim, J. A. Rogers, R. G. Nuzzo, Adv. Mater. 2005, 17, 2336.

[10] Z. Zhu, E. Menard, K. Hurley, R. G. Nuzzo, J. A. Rogers, App. Phys. Lett. 2005, 86, 133507.

[11] M. A. Meitl, Z. Zhu, V. Kumar, K. Lee, X. Feng, Y. Huang, R. G. Nuzzo, J. A. Rogers, Nature Mater. 2006, 5, 33.

[12] D. Khang, H. Jiang, Y. Huang, J. A. Rogers, Science, 2006, 311, 208.

[13] Y. Sun, S. Kim, I. Adesida, J .A. Rogers, App. Phys. Lett. 2005, 87, 083501.

[14] K. Lee, Dr. J. Lee, H. Hwang, J. A. Rogers, R. G. Nuzzo, Small 2005, 1, 1164.

[15] (a) GaN and related Materials (Eds.: S. J. Pearton), Gordon and Breach, New York, 1997. (b) Group III Nitride Semiconductor Compounds (Eds.: B. Gil), Clarendon, Oxford, 1998.

[16] (a) U. Mishra, P. Parikh, Y. Wu, Proc. IEEE. 2002, 90, 1022. (b) S. J. Pearton, J. C. Zolper, R. J. Shul, F. Ren, J. Appl. Phys. 1999, 86, 1. (c) S. C. Jain, M. Willander, J. Narayan, R. Van Overstraeten, J. Appl. Phys. 2000, 87, 965.

[17] M. A. Khan, A. Bhattari, J. N. Kuznia, and D. T. Olson, App. Phys. Lett. 1993, 63, 1214.

[18] Typical Si anisotropic etch ratios in TMAH and $H_2O$ mixtures are reported from 12 to 50 in the direction <110>/<111>. Please see to the following references; (a) Fundamentals of Microfabrication, (Ed: M. Madou), CRC Press, New York, 1997. (b) D. L. Kendall, Ann. Rev. Mater. Sci. 1979, 9, 373.

[19] V. Kumar, L. Zhou, D. Selvanathan, and I. Adesida, J. Appl. Phys. 2002, 92, 1712.

[20] Silicon Processing for the VLSI Era, Vol. 1: Process Technology, (Ed: S. Wolf, R.N. Tauber) Lattice Press, 1999.

## STATEMENTS REGARDING INCORPORATION BY REFERENCE AND VARIATIONS

The following references relate to self assembly techniques which may be used in methods of the present invention to transfer, assembly and interconnect printable semiconductor elements via contact printing and/or solution printing techniques: (1) "Guided molecular self-assembly: a review of recent efforts", Jiyun C Huie Smart Mater. Struct. (2003) 12, 264-271; (2) "Large-Scale Hierarchical Organization of Nanowire Arrays for Integrated Nanosystems", Whang, D.; Jin, S.; Wu, Y.; Lieber, C. M. Nano Lett. (2003) 3(9), 1255-1259; (3) "Directed Assembly of One-Dimensional Nanostructures into Functional Networks", Yu Huang, Xiangfeng Duan, Qingqiao Wei, and Charles M. Lieber, Science (2001) 291, 630-633; and (4) "Electric-field assisted assembly and alignment of metallic nanowires", Peter A. Smith et al., Appl. Phys. Lett. (2000) 77(9), 1399-1401.

Where the terms "comprise", "comprises", "comprised", or "comprising" are used herein, they are to be interpreted as specifying the presence of the stated features, integers, steps, or components referred to, but not to preclude the presence or addition of one or more other feature, integer, step, component, or group thereof. Separate embodiments of the invention are also intended to be encompassed wherein the terms "comprising" or "comprise(s)" or "comprised" are optionally replaced with the terms, analogous in grammar, e.g.; "consisting/consist(s)" or "consisting essentially of/consist(s) essentially of" to thereby describe further embodiments that are not necessarily coextensive.

## Claims

1. A method of transferring a printable semiconductor element (300), said method comprising the steps of:

   providing a printable semiconductor structure (290) comprising a printable semiconductor element (300); and at least one bridge element (310) connected to said printable semiconductor element (300) and connected to a mother wafer (320), wherein said printable semiconductor element (300) and said bridge element (310) are at least partially undercut from said mother wafer (320); wherein said first bridge element (310) connects to less than the entire width or cross sectional area of a first end of said printable semiconductor element (300);
   contacting said printable semiconductor element (300) with a conformable transfer device having a contact surface, wherein contact between said contact surface and said printable semiconductor element (300) binds said printable semiconductor element (300) to said contact surface; and
   moving said conformable transfer device in a manner resulting in the fracture of said bridge element (310), thereby transferring said printable semiconductor element (300) from said mother wafer (320) to said conformable transfer device; thereby forming said contact surface having said printable semiconductor element (300) disposed thereon;
   contacting said printable semiconductor element (300) disposed on said contact surface with a receiving surface of a substrate; and
   separating said contact surface of said conformable transfer device and said printable semiconductor element (300), thereby transferring said printable semiconductor element (300) onto said receiving surface of said substrate.

2. The method of claim 1 comprising a step of registered transfer to said conformable transfer device.

3. The method of claim 1 wherein:

   said conformable transfer device is a conformable transfer device; optionally, wherein conformal contact is established between the contact surface of said conformable transfer device and an external surface of said printable semiconductor element (300); and/or,
   said conformable transfer device is an elastomeric stamp; and/or,
   said bridge element (310), said printable semiconductor element (300) and said mother wafer (320) are a unitary semiconductor structure;
   and/or,
   said printable semiconductor structure (290) further comprises a second bridge element (310) connected to said printable semiconductor element (300) and connected to a mother wafer (320), wherein said second bridge element (310) is at least partially undercut from said mother wafer (320); wherein said step of moving said conformable transfer device fractures said second bridge element (310).

## Patentansprüche

1. Verfahren zum Übertragen eines druckbaren Halbleiterelements (300), wobei das Verfahren die folgenden Schritte umfasst:

   Bereitstellen einer druckbaren Halbleiterstruktur (290), die ein druckbares Halbleiterelement (300) umfasst; und zumindest ein Brückenelement (310) mit einem druckbaren Halbleiterelement (300) und einem Mutter-Wafer (320) verbunden ist, wobei das druckbare Halbleiterelement (300) und das Brückenelement (310) zumindest teilweise aus dem Mutter-Wafer (320) unterschnitten sind; wobei sich das erste Brückenelement (310) mit weniger als der ganzen Breite oder Querschnittsfläche eines ersten Endes des druckbaren Halbleiterelements (300) verbindet;

Kontaktieren des druckbaren Halbleiterelements (300) mit einer konformen Übertragungsvorrichtung, die eine Kontaktoberfläche aufweist, wobei der Kontakt zwischen der Kontaktoberfläche und dem druckbaren Halbleiterelement (300) das druckbare Halbleiterelement (300) an die Kontaktoberfläche bindet; und Bewegen der konformen Übertragungsvorrichtung auf eine Weise, die zum Bruch des Brückenelements (310) führt, dabei wird das druckbare Halbleiterelement (300) vom Mutter-Wafer (320) zur konformen Übertragungsvorrichtung transferiert; dabei wird die Kontaktoberfläche gebildet, auf der das druckbare Halbleiterelement (300) angeordnet ist;

Kontaktieren des druckbaren Halbleiterelements (300), das auf der Kontaktoberfläche angeordnet ist, mit einer Aufnahmeoberfläche eines Substrats; und

Trennen der Kontaktoberfläche der konformen Übertragungsvorrichtung und des druckbaren Halbleiterelements (300), dadurch Übertragen des druckbaren Halbleiterelements (300) auf

die Aufnahmeoberfläche des Substrats.

2. Verfahren nach Anspruch 1, das einen Schritt registrierten Transfers zur konformen Übertragungsvorrichtung umfasst.

3. Verfahren nach Anspruch 1, wobei:

Die konforme Übertragungsvorrichtung eine konforme Übertragungsvorrichtung ist; optional, wobei der konforme Kontakt zwischen der Kontaktoberfläche der konformen Übertragungsvorrichtung und einer Außenfläche des druckbaren Halbleiterelements (300) hergestellt wird; und/oder, die konforme Übertragungsvorrichtung ein elastomerer Stempel ist; und/oder, das Brückenelement (310), das druckbare Halbleiterelement (300) und der Mutter-Wafer (320) einer einheitlichen Halbleiterstruktur sind; und/oder,

Die druckbare Halbleiterstruktur (290) ferner ein zweites Brückenelement (310) umfasst, das mit dem druckbaren Halbleiterelement (300) verbunden ist und mit einem Mutter-Wafer (320) verbunden ist, wobei das zweite Brückenelement (310) zumindest teilweise vom Mutter-Wafer (320) unterschnitten ist; wobei der Schritt der Bewegung der konformen Übertragungsvorrichtung das zweite Brückenelement (310) bricht.

**Revendications**

1. Un procédé de transfert d'un élément semi-conducteur imprimable, (300), ledit procédé comprenant les étapes consistant à :

fournir une structure semi-conductrice imprimable (290) comprenant un élément semi-conducteur imprimable (300) ; et au moins un élément pont (310) connecté audit élément semi-conducteur imprimable (300) et connecté à une tranche mère (320), ledit élément semi-conducteur imprimable (300) et ledit élément pont (310) étant au moins partiellement en retrait par rapport à ladite tranche mère (320) ; ledit premier élément pont (310) étant connecté à moins de la totalité de la largeur ou la surface de section transversale d'une première extrémité dudit élément semi-conducteur imprimable (300) ;

mettre en contact ledit élément semi-conducteur imprimable (300) avec un dispositif de transfert conformable ayant une surface de contact, le contact entre ladite surface de contact et ledit élément semi-conducteur imprimable (300) liant ledit élément semi-conducteur imprimable (300) à ladite surface de contact ; et

faire bouger ledit dispositif de transfert conformable d'une manière entraînant la fracture dudit élément pont (310), ce qui transfère ledit élément semi-conducteur imprimable (300) de ladite tranche mère (320) audit dispositif de transfert conformable ; ce qui forme ladite surface de contact ayant ledit élément semi-conducteur imprimable (300) disposé sur elle ;

mettre en contact ledit élément semi-conducteur imprimable (300) disposé sur ladite surface de contact avec une surface de réception d'un substrat ; et

séparer ladite surface de contact dudit dispositif de transfert conformable et ledit élément semi-conducteur imprimable (300), ce qui transfère ledit élément semi-conducteur imprimable (300) sur ladite surface de réception dudit substrat.

2. Le procédé de la revendication 1, comprenant une étape de transfert enregistré sur ledit dispositif de transfert conformable.

3. Le procédé de la revendication 1, dans lequel :

ledit dispositif de transfert conformable est un dispositif de transfert conformable ; éventuellement dans lequel un contact conforme est établi entre la surface de contact dudit dispositif de transfert conformable et une surface extérieure dudit élément semi-conducteur imprimable (300) ; et/ou,
ledit dispositif de transfert conformable est un timbre élastomère ; et/ou,
ledit élément pont (310), ledit élément semi-conducteur imprimable (300) et ladite tranche mère (320) sont une structure semi-conductrice unitaire ; et/ou,
ladite structure semi-conductrice imprimable (290) comprend en sus un deuxième élément pont (310) connecté audit élément semi-conducteur imprimable (300) et connecté à une tranche mère (320), ledit deuxième élément pont (310) étant au moins partiellement en retrait par rapport à ladite tranche mère (320) ; ladite étape consistant à faire bouger ledit dispositif de transfert conformable fracturant ledit deuxième élément pont (310).

FIG. 1a

Provide a bulk silicon wafer having a (111) orientation.

↓

Generate a plurality of channels having selected shapes, spacing and physical dimensions (e.g., length width and depth), for example using photolithography methods.

↓

*Optionally,* growing thermal oxide layer on external surface.

↓

Mask at least a portion of the side surfaces of the channels, for example using angled electron beam deposition of a mask material.

↓

*Optionally,* remove exposed thermal oxide layer.

↓

Fabricating printable semiconductor elements by etching between recessed features, for example using anisotropic etching techniques wherein etching between channels occurs preferentially along <110> directions while preserving the (111) planes.

↓

Releasing printable semiconductor elements from the silicon wafer, for example by contacting with an elastomeric stamp.

↓

*Optionally,* refinishing the external surface of the silicon wafer, for example by processing that generates a flat and/or smooth surface

Multiple repetition processing of silicon wafer

# FIG. 1b

# FIG. 1c

# FIG. 1d

Anisotropic etching of unmasked regions;
generation of free-standing structures

# FIG. 1e

# FIG. 1f

**FIG. 2a**

**FIG. 2b**

31

FIG. 2c

FIG. 2d

FIG. 3a

FIG. 3b

FIG. 3c

FIG. 3d

FIG. 3e

FIG. 3f

FIG. 4a

FIG. 4b

FIG. 4c

FIG. 4d

**FIG. 5a**

**FIG. 5b**

**FIG. 5c**

FIG. 6a

FIG. 6b

FIG. 6c

FIG. 6d

FIG. 6e

FIG. 6f

FIG. 7a

FIG. 7b

FIG. 8a

FIG. 8b

FIG. 8c

FIG. 9a

FIG. 9b

FIG. 9c

**FIG. 10a**

trenches etched in Si (111)

typically ~10 μm

**FIG. 10b**

oxidation of Si and angled metal deposition

**FIG. 10c**

oxide and silicon etched to
undercut ribbons

~0.5 μm

$\langle 1\bar{1}0 \rangle$

**FIG. 10d**

ribbons just prior to release

10 μm

**FIG. 10e**

released ribbons

60 μm

**FIG. 11a**

**FIG. 11b**

apply stamp to
donor substrate

retrieve ribbons

print ribbons onto
plastic sheet

**FIG. 12a**

**FIG. 12b**

**FIG. 12c**

**FIG. 12d**

**FIG. 12e**

**FIG. 12f**

**FIG. 13a**

**FIG. 13b**

## FIG. 14a

2 DEG

| AlGaN layer: undoped, 18 nm |
| GaN Buffer layer : undoped, 0.6 $\mu$m |
| Transition layer (AlN) : 0.6 $\mu$m |
| Si (111) wafer (sacrificial wafer) |

## FIG. 14b

Gate (Ni/Au)

Source          Drain

| AlGaN layer |
| Undoped GaN buffer layer |
| Transition layer (AlN) |
| PU |
| PET |

## FIG. 14c

Breaking point

Freestanding $\mu$s-GaN

(111) Si surface

(110) Si surface

Ohmic contact on GaN stack

Ti/Al/Mo/Au

Si wafer

## FIG. 15a

Ribbon pattern with PEO/Cr

## FIG. 15b

ICP etching of GaN

PEO

## FIG. 15c

TMAH etching of underlying Si

## FIG. 15d

Transfer to PDMS

## FIG. 15e

Spincast PU on plastic

PU

PET

## FIG. 15f

Contact PDMS to PET
UV exposure

## FIG. 15g

Removing oxide & metal contact
Gate (Schottky contact, Ni/Au)

## FIG. 15h

FIG. 16a

FIG. 16b

FIG. 16c

FIG. 16d

FIG. 16e

FIG. 16f

FIG. 17a

FIG. 17b

FIG. 17c

FIG. 17d

FIG. 18a

FIG. 18b

FIG. 18c

**1** — SiO$_2$ / Si(111)

STS–ICPRIE
BOE etching

**2** — ~5 µm / ~500 nm

angled metal evaporation

**3** — Au/Cr

KOH etching

**4** — intermediate state

metal cleaning

**5** — ~100 nm / Si ribbons

# FIG. 19

FIG. 20a

FIG. 20b

FIG. 20c

FIG. 20d

FIG. 20e

FIG. 20f

FIG. 20g

FIG. 20h

FIG. 21a FIG. 21b FIG. 21c

FIG. 21d FIG. 21e

FIG. 22a FIG. 22b FIG. 22c

FIG. 22d FIG. 22e FIG. 22f

**FIG. 23a**

**FIG. 23b**

**FIG. 23c**

**FIG. 23d**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 145574
- US 11145542 B

- US 2004234231 A


**Non-patent literature cited in the description**

- GARNIER, F. ; HAJLAOUI, R. ; YASSAR, A. ; SRIVASTAVA, P. *Science,* vol. 265, 1684-1686
- DUAN, X. ; NIU, C. ; SAHL, V. ; CHEN, J. ; PARCE, J. ; EMPEDOCLES, S. ; GOLDMAN, J. *Nature,* vol. 425, 274-278
- DUAN ; MITZI, D.B ; KOSBAR, L.L. ; MURRAY, C.E. ; COPEL, M. ; AFZALI, A. et al. *Nature,* vol. 428, 299-303
- RIDLEY, B.A. ; NIVI, B. ; JACOBSON, J.M. *Science,* 1999, vol. 286, 746-749
- Y. XIA ; P. YANG ; Y. SUN ; Y. WU ; B. MAYERS ; B. GATES ; Y. YIN ; F. KIM ; H. YAN. *Adv. Mater.,* 2003, vol. 15, 353
- C. M. LIEBER. *Mater. Res. Soc. Bull.,* 2003, vol. 28, 486
- M. C. MCALPINE ; R. S. FRIEDMAN ; C. M. LIEBER. 93. *Proc. IEEE,* 2005, 1357
- M. LAW ; J. GOLDBERGER ; P. YANG. *Ann. Rev. Mater. Res.,* 2004, vol. 34, 83
- P. YANG. *Mater. Res. Soc. Bull.,* 2005, vol. 30, 85
- Z. R. DAI ; Z. W. PAN ; Z. L. WANG. 13. *Adv. Funct. Mater.,* 2003, 9
- *Pure Appl. Chem.,* 2002, vol. 74 (9
- Y. YIN ; A. P. ALIVISATOS. *Nature,* 2005, vol. 437, 664
- I. GUR ; N. A. FROMER ; M. L. GEIER ; A. P. ALIVISATOS. *Science,* 2005, vol. 310, 462
- L. SAMUELSON ; M. T. BJÖRK ; K. DEPPER ; M. LARSSON ; B. J. OHLSSON ; N. PANEV ; A. I. PERSSON ; N. SKÖLD ; C. THELANDER ; L. R. WALLENBERG. *Physica E,* 2004, vol. 21, 560
- L. A. BAUER ; N. S. BIRENBAUM ; G. J. MEYER. *J. Mater. Chem.,* 2004, vol. 14, 517
- Y. CUI ; Q. WEI ; H. PARK ; C. M. LIEBER. *Science,* 2001, vol. 293, 1289
- Z. TANG ; N. A. KOTOV. *Adv. Mater.,* 2005, vol. 17, 951
- X. DUAN ; C. NIU ; V. SAHI ; J. CHEN ; J. W. PARCE ; S. EMPEDOCLES ; J. L. GOLDMAN. *Nature,* 2003, vol. 425, 274

- R. S. FRIEDMAN ; M. C. MCALPINE ; D. S. RICKETTS ; D. HAM ; C. M. LIEBER. *Nature,* 2005, vol. 434, 1085
- E. MENARD ; K. J. LEE ; D.-Y. KHANG ; R. G. NUZZO ; J. A. ROGERS. *Appl. Phys. Lett.,* 2004, vol. 84, 5398
- Y. SUN ; S. MACK ; J. A. ROGERS. *Proc. Intl. Electron Device Meeting (IEEE),* 2005
- E. MENARD ; R. G. NUZZO ; J. A. ROGERS. *Appl. Phys. Lett.,* 2005, vol. 86, 093507
- Z.-T. ZHU ; E. MENARD ; K. HURLEY ; R. G. NUZZO ; J. A. ROGERS. *Appl. Phys. Lett.,* 2005, vol. 86, 133507
- Y. SUN ; J. A. ROGERS. *Nano Lett,* 2004, vol. 4, 1953
- Y. SUN ; D.-Y. KHANG ; F. HUA ; K. HURLEY ; R. G. NUZZO ; J. A. ROGERS. *Adv. Funct. Mater.,* 2005, vol. 15, 30
- Y. SUN ; S. KIM ; I. ADESIDA ; J. A. ROGERS. *Appl. Phys. Lett.,* 2005, vol. 87, 083501
- Y. SUN ; H.-S. KIM ; E. MENARD ; S. KIM ; G. CHEN ; I. ADESIDA ; R. DETTMER ; R. CORTEZ ; A. TEWKSBURY ; J. A. ROGERS. *Appl. Phys. Lett.*
- R. H. REUSS ; B. R. CHALAMALA ; A. MOUSSESSIAN ; M. G. KANE ; A. KUMAR ; D. C. ZHANG ; J. A. ROGERS ; M. HATALIS ; D. TEMPLE ; G. MODDEL. *Proc. IEEE,* 2005, vol. 39, 1239
- D. C. DUFFY ; C. MCDONALD ; O. J. A. SCHUELLER ; G. M. WHITESIDES. *Anal. Chem.,* 1998, vol. 70, 4974
- S. M. SZE. Semiconductor Devices, Physics and Technology. Wiley, 1985
- G. EFTEKHARI. *Phys. Status Solidi A-Appl. Res.,* 1993, vol. 140, 189
- H.-I. CHEN ; C.-K. HSIUNG ; Y.-I CHOU. *Semicond. Sci. Technol.,* 2003, vol. 18, 620
- S. FORMENT ; M. BIBER ; R. L. VAN MEIRHAEGHE ; W. P. LEROY ; A. TÜRÜT. *Semicond. Sci. Technol.,* 2004, vol. 19, 1391

- **L. STEPHEN ; S. E. BUTNER.** Gallium Arsenide Digital Intergrated Circuit Design. McGraw-Hill, 1990
- **K. NOMURA ; H. OHTA ; A. TAKAGI ; T. KAMIYA ; M. HIRANO ; H. HOSONO.** *Nature,* 2004, vol. 432, 488
- **D. B. MITZI ; L. L. KOSBAR ; C. E. MURRAY ; M. COPEL ; A. AFZALI.** *Nature,* 2004, vol. 428, 299
- **S. UCJIKOGA.** *MRS Bull,* 2002, vol. 27, 881
- **X. DUANG ; C. NIU ; V. SAHI ; J. CHEN ; J. W. PARCE ; S. EMPEDOCLES ; J. L. GOLDMAN.** *Nature,* 2003, vol. 425, 274
- **Y. SUN ; J. A. ROGERS.** *J. A. Nano Lett,* 2004, vol. 4, 1953
- **A. S. SEDRA ; K. C. SMITH.** Microelectronic Circuits. Oxford University Press, 1998
- Small Signal Equivalent Circuit Extraction from a Gallium Arsenide MESFET device. **M. C, LAU.** M.S. thesis. Virginia Polytechnic Institution and State University, 1997
- **L. B. FREUND.** *Intl. J. Solids Struct.,* 2000, vol. 37, 185
- **C. P. KUO ; S. K. VONG ; R. M. COHEN ; G. B. STRINGFELLOW.** *J. Appl. Phys.,* 1985, vol. 57, 5428
- **Y. HUANG ; X. DUAN ; Q. WEI ; C. M. LIEBER.** *Science,* 2001, vol. 291, 630
- **M. A. MEITL ; Y. ZHOU ; A. GAUR ; S. JEON ; M. L. USREY ; M. S. STRANO ; J. A. ROGERS.** *Nano Lett,* 2004, vol. 4 (9), 1643
- **R. S. FRIEDMAN.** *Nature,* 2005, vol. 434, 1085
- **E. MENARD ; R.G. NUZZO ; J.A. ROGERS.** *Appl. Phys. Lett.,* 2005, vol. 86
- **K. J. LEE ; M. J. MOTALA ; M. A. MEITL ; W. R. CHILDS ; E. MENARD ; A. K. SHIM ; J. A. ROGERS ; R. G. NUZZO.** *Adv. Mater.,* 2005, vol. 17, 2332
- **M. A. MEITL ; Z.-T. ZHU ; V. KUMAR ; K. J. LEE ; X. FENG ; Y. Y. HUANG ; I. ADESIDA ; R. G. NUZZO ; J. A. ROGERS.** *Nat. Mater.,* 2006, vol. 5, 33
- **D.Y. KHANG ; H. JIANG ; Y. HUANG ; J.A. ROGERS.** *Science,* 2006, vol. 311, 208
- **S. R. FORREST.** *Nature,* 2004, vol. 428, 911
- **J. A. ROGERS ; K. E. PAUL ; R. J. JACKMAN ; G. M. WHITESIDES.** *Appl. Phys. Lett.,* 1997, vol. 70, 2658
- **S. SZE.** Semiconductor Devices: Physics and Technology. Wiley, 2002, 190-192
- **R. REUSS et al.** *Proc. IEEE.,* 2005, vol. 39, 1239
- **J. A. ROGERS ; Z. BAO ; K. BALDWIN ; A. DODABALAPUR ; B. CRONE ; V. R. RAJU ; V. KUCK ; H. KATZ ; K. AMUNDSON ; J. EWING.** *Proc. Nat. Acad. Sci.,* 2001, vol. 98, 4835
- **J. H. SCHÖN ; S. BERG ; C. KLOC ; B. BATLOGG.** *Science,* 2000, vol. 287, 1022
- **A. DODABALAPUR ; L. TORSI ; H. E. KATZ.** *Science,* 1995, vol. 268, 270
- **B. S. ONG ; Y. WU ; P. LIU ; S. GARDNER.** *J. Am. Chem. Soc.,* 2004, vol. 126, 3378
- **C. R. KAGAN ; D. B. MITZI ; C. D. DIMITRAKOPOULOS.** *Science,* 1999, vol. 286, 945
- **J. KWON ; D. KIM ; H. CHO ; K. PARK ; J. JUNG ; J. KIM ; Y. PARK ; T. NOGUCHI.** *IEEE Trans. Electron.,* 2005, vol. 466, 7
- **K. LEE ; M. J. MOTALA ; M. A. MEITL ; W. R. CHILDS ; E. MENARD ; A. K. SHIM ; J. A. ROGERS ; R. G. NUZZO.** *Adv. Mater.,* 2005, vol. 17, 2336
- **Z. ZHU ; E. MENARD ; K. HURLEY ; R. G. NUZZO ; J. A. ROGERS.** *App. Phys. Lett.,* 2005, vol. 86, 133507
- **M. A. MEITL ; Z. ZHU ; V. KUMAR ; K. LEE ; X. FENG ; Y. HUANG ; R. G. NUZZO ; J. A. ROGERS.** *Nature Mater,* 2006, vol. 5, 33
- **D. KHANG ; H. JIANG ; Y. HUANG ; J. A. ROGERS.** *Science,* 2006, vol. 311, 208
- **Y. SUN ; S. KIM ; I. ADESIDA ; J .A. ROGERS.** *App. Phys. Lett.,* 2005, vol. 87, 083501
- **K. LEE ; DR. J. LEE ; H. HWANG ; J. A. ROGERS ; R. G. NUZZO.** *Small,* 2005, vol. 1, 1164
- **GORDON ; BREACH.** *GaN and related Materials,* 1997
- **CLARENDON.** *Group III Nitride Semiconductor Compounds,* 1998
- **U. MISHRA ; P. PARIKH ; Y. WU.** *Proc. IEEE.,* 2002, vol. 90, 1022
- **S. J. PEARTON ; J. C. ZOLPER ; R. J. SHUL ; F. REN.** *J. Appl. Phys.,* 1999, vol. 86, 1
- **S. C. JAIN ; M. WILLANDER ; J. NARAYAN ; R. VAN OVERSTRAETEN.** *J. Appl. Phys.,* 2000, vol. 87, 965
- **M. A. KHAN ; A. BHATTARI ; J. N. KUZNIA ; D. T. OLSON.** *App. Phys. Lett.,* 1993, vol. 63, 1214
- Fundamentals of Microfabrication. CRC Press, 1997
- **D. L. KENDALL.** *Ann. Rev. Mater. Sci.,* 1979, vol. 9, 373
- **V. KUMAR ; L. ZHOU ; D. SELVANATHAN ; I. ADESIDA.** *J. Appl. Phys.,* 2002, vol. 92, 1712
- Silicon Processing for the VLSI Era. Process Technology. Lattice Press, 1999, vol. 1
- **JIYUN C HUIE.** Guided molecular self-assembly: a review of recent efforts. *Smart Mater. Struct.,* 2003, vol. 12, 264-271
- **WHANG, D. ; JIN, S. ; WU, Y. ; LIEBER, C. M.** Large-Scale Hierarchical Organization of Nanowire Arrays for Integrated Nanosystems. *Nano Lett,* 2003, vol. 3 (9), 1255-1259

- **YU HUANG ; XIANGFENG DUAN ; QINGQIAO WEI ; CHARLES M. LIEBER.** Directed Assembly of One-Dimensional Nanostructures into Functional Networks. *Science,* 2001, vol. 291, 630-633

- **PETER A. SMITH et al.** Electric-field assisted assembly and alignment of metallic nanowires. *Appl. Phys. Lett.,* 2000, vol. 77 (9), 1399-1401